# EUROPEAN PATENT SPECIFICATION

(11) **EP 2 068 602 B1**
(45) Date of publication and mention of the grant of the patent: **29.06.2016**
(21) Application number: 07828523.6
(22) Date of filing: 27.09.2007
(51) Int. Cl.: H05H 1/24, C23C 14/24, C23C 14/32

(54) **RADIALLY ENLARGED TYPE PLASMA GENERATING APPARATUS**
RADIAL ERWEITERTE PLASMAERZEUGUNGSVORRICHTUNG
APPAREIL GÉNÉRATEUR DE PLASMA DE TYPE À RAYON ÉLARGI

(30) Priority: 30.09.2006 JP 2006270201
(43) Date of publication of application: 10.06.2009
(73) Proprietor: Ferrotec Corporation, Tokyo 1040031 (JP)
(72) Inventor: SHIINA, Yuichi, Chuo-ku Tokyo 104-0031 (JP)
(74) Representative: Patentanwälte Olbricht Buchhold Keulertz
(86) International application number: PCT/JP2007/068777
(87) International publication number: WO 2008/038700

(56) References cited:
- EP-A- 1 195 792
- WO-A-2005/074334
- WO-A1-2005/074334
- JP-A- 2 194 167
- JP-A- 02 194 167
- JP-A- 07 150 340
- JP-A- 09 190 794
- JP-A- 10 505 633
- JP-A- 2002 105 628
- JP-A- 2002 294 433
- US-A- 5 670 217

## Description

### FIELD OF THE INVENTION

The present invention relates to a plasma generating apparatus installed with a droplet eliminating portion by which a plasma is generated by a vacuum arc discharge performed in an arc discharge portion set under a vacuum atmosphere and cathode material particles (referred to as droplets) by-produced from a cathode at a plasma generating time.

### BACKGROUND ART

In general, it is known that thin film is formed on the surface of solid material in plasma and a solid surface characteristic is improved by injecting an ion. Film formed by using of a plasma including metal ion and metalloid ion can strengthen the characteristics of abrasion resistance and corrosion resistance of a solid surface, so that it is useful as protective film, optics thin film and transparent conductivity film. In particular, the carbon film using carbon plasma is a diamond-like-carbon film (referred to as DLC film) comprising of amorphous conglomerate of diamond structure and graphite structure, so it has a high utility value.

As an approach to generate a plasma including metal ion and metalloid ion, there is a vacuum arc plasma method. A vacuum arc plasma is formed by an arc discharge generated between cathode and anode, namely after a cathode material evaporates from a cathode spot existing on the cathode surface, the plasma is formed by this cathode evaporation material. In addition, when a reactivity gas and/or an inert gas (rare gas) were introduced as ambient atmosphere gas, the reactivity gas and/or the inert gas also are ionized at the same time. By performing the thin film formation and the ion injection on solid surface by means of such a plasma, surface treatment process can be carried out.

Generally, in the vacuum arc discharge, vacuum arc plasma constituent particles such as cathode material ion, electron and cathode material neutral particle (atom and molecule) are emitted from the cathode spot, and at the same time, the cathode material fine particles referred to as droplets of size of less than sub-micron to several hundred micron (0.01-1000µm) are also emitted. However, a problem appeared in surface treatment such as a filming is the generation of droplet. When said droplets bond on the object surface to be treated, the uniformity of thin film formed on said object surface to be treated is lost, and it becomes the defect product of thin film.

As a method to solve above problem of droplets, there is a magnetic filter method (P.J. Martin, R.P. Netterfield and T.J. Kinder, Thin Solid Films 193/194 (1990) 77) (non-patent document 1). This magnetic filter method transports said vacuum arc plasma to a treating portion through a curved droplet collecting duct. According to this method, the emitted droplets are adhesion-captured (collected) on an inner circumferential wall of said duct, so that there is obtained the plasma flow that hardly includes the droplets at the duct exit. In addition, curved magnetic field is formed by means of magnet disposed along the duct, and the plasma stream is bent by said curved magnetic field, so that plasma P is effectively guided to a plasma processing portion.

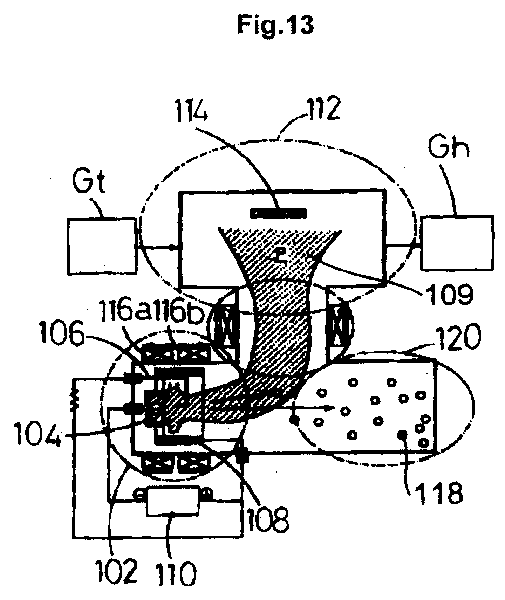

In Japanese Patent Laid-Open No. 2002-8893 (patent document 1), the plasma processing apparatus including the droplet collecting portion is disclosed. FIG. 13 is a schematic outlined diagram of conventional plasma processing apparatus. In plasma generating portion 102, the electricity spark is occurred between cathode 104 and trigger electrode 106, and the vacuum arc is generated between cathode 104 and anode 108, so that the plasma is generated. In the plasma generating portion 102, the power source 110 is connected to generate the electricity spark and the vacuum arc discharge, and the plasma stabilizing magnetic field generators 116a, 116b are disposed to stabilize the plasma 109. The plasma 109 is guided from the plasma generating portion 102 to the plasma processing portion 112, and the object to be treated 114 arranged in the plasma processing portion 112 is received the surface treatment by the plasma 109. Additionally, the reactivity gas is introduced as necessary by the gas introduction system Gt connected to the plasma processing portion 112 and the reaction gas and the plasma flow are exhausted by the gas exhaust system Gh.

The plasma 109 emitted from the plasma generating portion 102 is bent in the direction not facing to the plasma generating portion 102 by the magnetic field and the plasma flows into the plasma processing portion 112. At the position facing to the plasma generating portion 102, there is disposed the droplet collecting portion 120 by which the cathode material fine particles (droplets) by-produced from the cathode at the generating time of plasma 109 are collected. Therefore, the droplets 118 not being affected by the magnetic field advance to the droplet collecting portion and are collected by it, so that it is prevented that the droplets 118 penetrate into the plasma processing portion 112.
[Patent Document 1] Japanese Patent Laid-Open No. 2002-8893
[Non-Patent Document 1] P.J. Martin, R.P. Netterfield and T.J. Kinder, Thin Solid Films193/194 (1990) 77

In Japanese Patent Laid-Open No. 2-194167 A, the vacuum arc deposition apparatus is disclosed. In this apparatus, a concentric hollow coil is placed in front of the central axis through the vaporization surface on the arc vaporization source. The plasma generated from said arc vaporization source is guided toward a substrate, along the lines of magnetic force from the magnetic field that leaks out of the coil edge, and coats the said substrate. On the other hand, neutral droplets, on which no guidance effect by the said magnetic field is induced, are reduced proportionally.

In U.S. Patent No. 5,670,217, the ion implanter equipped with a particle collector that adsorbs droplets is disclosed. This particle collector is constructed in tubular form from a material that has high surface area, such as the foam aluminum material, and is placed directly in front of the implantation chamber. Droplets with low rectilinearity in their trajectory collide with the inner surface of said particle collector, and thus said droplets are removed by being adsorbed by said inner surface.

### DISCLOSURE OF THE INVENTION

### PROBLEM TO BE SOLVED BY THE INVENTION

In a conventional plasma processing apparatus shown in FIG. 13, the droplets 118 which do not receive the effect of said magnetic field are collected to the droplet collecting portion 120, but there was the case that the charged droplets in which electric charge was given by interaction with plasma 109 were guided to the plasma processing portion 112 by the magnetic field. Furthermore, the droplets of small particle size which are not collected in the droplet collecting portion 120 are accompanied with plasma flow and guided to the plasma processing portion 112. Therefore, since the droplets mixed in plasma flow without being collected such as charged droplets and small droplets bond on the object surface to be treated, the uniformity of thin film formation and surface modification on said object surface to be treated is lost, and a problem to decrease surface property of the object to be treated has occurred.

Besides, in the magnetic filter method disclosed in non-patent document 1, as described above, since the plasma flow is bent by the curved magnetic field and the plasma moves efficiently to the plasma processing portion, the charged droplets and small droplets mixed in the plasma flow are guided to the plasma processing portion without being removed, so that it can not be prevented that they collide or bond on the object surface to be treated.

The droplet removal method disclosed in JP 2-194167 A also utilizes magnetic field, and therefore is ineffective in removing the charged droplets in which electric charge was given by interaction with plasma. Furthermore, the method disclosed in JP 2-194167 A makes no provision against the droplets of small particle size.

As for the droplet removal method disclosed in US 5,670,217, its effectiveness is dependent on the low rectilinearity of the droplet trajectory. Therefore, the method is ineffective against small droplets that have highly rectilinear trajectory.

In recent plasma filming technology, the filming with the use of various kinds of material is done, and the improvement of filming precision such as smoothness due to the filming apparatus is demanded. As described above, since the droplet bond strongly affects to the filming precision, improvement of droplet removing efficiency in plasma generating apparatus is needed. In addition, as shown in FIG.13, when many magnetic field generators for droplet removal are installed, complexity of apparatus occurs and there was a problem to bring about increase in cost for apparatus and filming treatment.

Therefore, the purpose of the present invention is to remove efficiently droplets mixed in the plasma generated in the plasma generating apparatus, to constitute the droplet removing portion easily and cheaply, and to present the plasma generating apparatus by which the surface treating precision such as filming can be improved by using of high purity plasma.

### MEANS TO SOLVE THE PROBLEM

The present invention is proposed to solve the above problems. In a plasma generating apparatus including a plasma generating portion by which a plasma is generated by a vacuum arc discharge under a vacuum atmosphere and a plasma advancing path in which said plasma generated by said plasma generating portion progresses to a plasma treating portion side, the first form of the present invention is said plasma generating apparatus characterized in that a droplet removing portion removing cathode material particles (referred to as droplets) by-produced from a cathode at a plasma generating time is disposed in said plasma advancing path, wherein said plasma removing portion includes a radially enlarged tube, an introduction side radially reduced tube connected to a plasma introducing side initial end of said radially enlarged tube, a discharge side radially reduced tube connected to a plasma discharge side terminal end of said radially enlarged tube, and stepped portions formed at said initial end and said terminal end of said radially enlarged tube.

The second form of the present invention is the plasma generating apparatus of said first form, wherein tube axes of said introduction side radially reduced tube and/or said discharge side radially reduced tube are inclinedly disposed for a tube axis of said radially enlarged tube, and said introduction side radially reduced tube and/or said discharge side radially reduced tube are connected to said radially enlarged tube.

The third form of the present invention is the plasma generating apparatus of said first or second form, wherein said tube axes of said introduction side radially reduced tube and said discharge side radially reduced tube are disposed so as to intersect each other.

The fourth form of the present invention is the plasma generating apparatus of said second or third form, wherein said plasma advancing path includes a straightly advancing tube, said introduction side radially reduced tube is connected vertically or almost vertically to said straightly advancing tube, and a droplet collecting portion is disposed at a terminal end of said straightly advancing tube.

The fifth form of the present invention is the plasma generating apparatus of any of said second to fourth forms, wherein said radially enlarged tube is composed of an inner circumferential tube and an outer circumferential tube, and said inner circumferential tube is freely inserted to and removed from said outer circumferential tube.

The sixth form of the present invention is the plasma generating apparatus of said fifth form, wherein a plurality of droplet collecting plates are installed on an inner wall of said inner circumferential tube.

The seventh form of the present invention is the plasma generating apparatus of said sixth form, wherein a rough surface processing is made on a surface of said droplet collecting plate.

The eighth form of the present invention is the plasma generating apparatus of said seventh form, wherein said droplet collecting plates are inclinedly disposed for said introduction side radially reduced tube.

The ninth form of the present invention is the plasma generating apparatus of any of said first to eighth forms, wherein an aperture is arranged in said introduction side radially reduced tube and said discharge side radially reduced tube.

The tenth form of the present invention is the plasma generating apparatus of any of said first to ninth forms, wherein a plurality of said radially enlarged tubes are connected through a radially reduced tube.

The eleventh form of the present invention is the plasma generating apparatus of any of said first to tenth forms, wherein one or more rotational magnetic field applying means generating a rotational magnetic field in a cross section circumferential direction of said radially enlarged tube is installed, said rotational magnetic field is applied to said plasma by said rotational magnetic field applying means, and said plasma progresses through said radially enlarged tube while rotating, so that said droplets are removed by a centrifugal force.

The twelfth form of the present invention is the plasma generating apparatus of said eleventh form, wherein said rotational magnetic field applying means is constituted from a plurality of vibration magnetic field generators generating vibration magnetic fields, a plurality of vibration magnetic fields with different phase and different vibration direction are generated by said vibration magnetic field generators, so that said rotational magnetic field is synthesized from said vibration magnetic fields.

The thirteenth form of the present invention is the plasma generating apparatus of any of said first to tenth forms, wherein one or more apertures having a passage hole at an eccentric position are arranged in said radially enlarged tube, a magnetic field generating means is disposed on an outer circumference of said radially enlarged tube to pass said plasma in said eccentric passage hole of said aperture, and said plasma passes in said eccentric passage hole of said aperture while curving in said radially enlarged tube by said magnetic field based on said magnetic field generating means, so that said droplets are separated from said plasma at said curving time and said droplets are removed by collision with a wall surface of said aperture.

The 14th form of the present invention is the plasma generating apparatus of said thirteenth form, wherein a plurality of apertures are arranged in said radially enlarged tube, and the adjacent eccentric passage holes are disposed so as to shift their positions each other, so that said droplets accompanied with said plasma passing through said eccentric passage hole of said aperture of an initial side are removed by collision with said wall surface of next aperture and said plasma passes through said eccentric passage hole of next aperture.

The 15th form of the present invention is the plasma generating apparatus of said thirteenth or 14th form, wherein said magnetic field generating means is configured with a slant magnetic field generator, by which a slant magnetic field is formed in a slant direction for an axis direction of said radially enlarged tube and said plasma passes through said eccentric passage hole of said aperture by said slant magnetic field.

The 16th form of the present invention is the plasma generating apparatus of any of said first to 15th forms, wherein a duct portion for transporting said plasma includes at least said introduction side radially reduced tube, said radially enlarged tube and said discharge side radially reduced tube, and said duct portion is electrically insulated with said plasma generating portion and said plasma treating portion.

The 17th form of the present invention is the plasma generating apparatus of any of said first to 16th forms, wherein a bias voltage is applied to said duct portion.

The 18th form of the present invention is the plasma generating apparatus of any of said first to 17th forms, wherein a quantity of physical property is measured by inserting a probe into said duct portion or by utilizing said duct portion as said probe.

The 19th form of the present invention is the plasma generating apparatus of any of said first to 18th forms, wherein one or combination of effective total length, diameter, bending number and summation of bending angle in said plasma advancing path is set so as to satisfy a droplet reduction condition.

The 20th form of the present invention is the plasma generating apparatus of said 19th form, wherein said effective total length is set at 1600-900 mm.

The 21 st form of the present invention is the plasma generating apparatus of said 19th form, wherein said diameter is set at 200-90 mm.

The 22nd form of the present invention is the plasma generating apparatus of said 19th form, wherein said bending number is set at 3-1.

The 23rd form of the present invention is the plasma generating apparatus of said 19th form, wherein said summation of bending angle is set at 150-90 degrees.

The 24th form of the present invention is the plasma generating apparatus of any of said first to 23rd forms, wherein an arc current value in said plasma generating portion is adjusted in a range of 140-30 A.

### EFFECT OF THE INVENTION

According to the first form of the present invention, since said plasma removing portion disposed in said plasma advancing path includes a radially enlarged tube, an introduction side radially reduced tube connected to a plasma introducing side initial end of said radially enlarged tube, a discharge side radially reduced tube connected to a plasma discharge side terminal end of said radially enlarged tube, and stepped portions formed at said initial end and said terminal end of said radially enlarged tube, the plasma flow derived from said introduction side radially reduced tube to said radially enlarged tube is diffused by the radially enlarging action of said plasma advancing path based on said radially enlarged tube. By the diffusion of said plasma flow, as the droplets mixing in said plasma diffuse in said radially enlarged tube, the droplets collide with neighborhood of said stepped portion and the inner side wall of said radially enlarged tube and are recovered. In addition, when the plasma flow existing in said radially enlarged tube is egested, the droplets scattering to the inner wall surface of said radially enlarged tube collide with said stepped portion by the radially reducing action from said radially enlarged tube to said discharge side radially reduced tube, so that the droplets bond and recovered on said stepped portion, and the re-mixing of droplets can be prevented without being joined to the plasma flow. Therefore, by bonding the droplets on the neighborhood of said stepped portion and the inner side wall of said radially enlarged tube, they are fully recovered, so that it is possible to remove efficiently the droplets in said plasma advancing path. Moreover, when the center axes do not coincide with decenter among the radially enlarged tube and the introduction side radially reduced tube and/or the discharge side radially reduced tube, it becomes easy to separate the droplets from the plasma flow and the collecting efficiency of droplets becomes higher. Besides, by forming said radially enlarged tube in said plasma advancing path, it is possible to construct the droplet removing portion easily and cheaply, and the precision of surface treatment such as filming is improved by using of the high purity plasma obtained by improvement of droplet removing efficiency, so that it is possible to improve surface modification of the object surface to be treated and uniformity of the formed film still more.

In the present invention, even if the tube axes of said introduction side radially reduced tube and/or the discharge side radially reduced tube are disposed linearly with the tube axis of said radially enlarged tube without bending, it is possible to efficiently recover and remove the droplets diffused in said radially enlarged tube by the radially enlarging action and the radially reducing action of said plasma advancing path by using of said radially enlarged tube. However, according to the second form of the present invention, since the tube axes of said introduction side radially reduced tube and/or said discharge side radially reduced tube are inclinedly disposed for a tube axis of said radially enlarged tube, and said introduction side radially reduced tube and/or said discharge side radially reduced tube are connected to said radially enlarged tube, the straightly advancing droplets are separated from the plasma flow by the bending of the plasma advancing path, and they collide with the inner wall surface of the radially enlarged tube and/or the inner wall surface of the discharge side radially reduced tube and can be recovered by bonding. The droplets reflected by the inner wall of said radially enlarged tube without being adsorbed collide with the stepped portion and are recovered, so that it becomes possible to remove the droplets efficiently. By the term of and/or, said bending can be disposed in the introduction side only, the discharge side only, or both of the introduction side and the discharge side. Therefore, it is possible to separate the droplets mixing in the plasma flow with high efficiency, and by ejecting the highly purified plasma flow from said discharge side radially reduced tube, it is possible to improve the droplet removing efficiency. In addition, by decentering the tube axes of the introduction side radially reduced tube and the radially enlarged tube, or by decentering the tube axes of the discharge side radially reduced tube and the radially enlarged tube, it is as mentioned above that the droplet recovering efficiency is improved than the case of coincidence of tube axes.

In parallel arrangement that the tube axis directions of said introduction side radially reduced tube and the discharge side radially reduced tube are parallel or approximately parallel each other, since the droplets mixing in the neighborhood of center of the plasma flow passing through said radially enlarged tube are not separated, the droplets pass through said discharge side radially reduced tube, so that the droplets might pass to the plasma treating portion (called plasma processing portion). However, according to the third form of the present invention, since said tube axes of said introduction side radially reduced tube and said discharge side radially reduced tube are disposed so as to intersect each other, the plasma flow ejected from said radially enlarged tube collides with the inner wall of said discharge side radially reduced tube intersecting for said introduction side radially reduced tube, and passes through said discharge side radially reduced tube while meandering. Therefore, after the droplets were collected due to adhesion by colliding with said stepped portion neighborhood and the inner side wall of said radially enlarged tube, even if the droplets mixing in the center neighborhood of the plasma flow were ejected from said radially enlarged tube, the droplets advance straightly and collide with the inner wall of said discharge side radially reduced tube, so that they are recovered by adhesion and it is possible to remove the droplets with higher efficiency.

According to the fourth form of the present invention, since said plasma advancing path includes a straightly advancing tube, said introduction side radially reduced tube is connected vertically or almost vertically to said straightly advancing tube, and a droplet collecting portion is disposed at a terminal end of said straightly advancing tube, a part of the droplets generated in said plasma generating portion advance straightly along said straightly advancing tube and they are collected and recovered in said droplet collecting portion. Therefore, since the plasma flow that a part of the droplets were removed flows into said introduction side radially reduced tube connected vertically or almost vertically to said straightly advancing tube by the bending action of the plasma advancing path, the highly efficient removal of the droplets becomes possible based upon the synergistic effect with the droplet removal due to the droplet removing portion in the plasma advancing path of the present invention.

In the case that the droplet removing portion is installed in the plasma advancing path, though the cleaning by exfoliation and recovery of the droplets adhering on the inner wall is necessary, the disassembling of plasma advancing path is accompanied with its cleaning, so that the operation efficacy of the plasma generating apparatus might drop. In there, according to the fifth form of the present invention, as said inner circumferential tube is freely inserted to and removed from said outer circumferential tube in said radially enlarged tube, said inner circumferential tube polluted by the droplets can be changed at the optional time, the cleaning efficiency of droplets improves and the plasma generating treatment can be done smoothly without decreasing the running efficiency of the plasma generating apparatus. A lot of droplet collecting plates are formed in the inner surface of said inner circumferential tube, and the cleaning and repair of the droplet collecting plates become easy by pulling out the inner circumferential tube. Although the inner circumferential tube may be electrically connected to the outer circumferential tube, the inner circumferential tube and the outer circumferential tube can be electrically insulated by fixing the inner circumferential tube to the outer circumferential tube through the insulating material such as insulating ring.

According to the sixth form of the present invention, since a plurality of droplet collecting plates are installed on an inner wall of said inner circumferential tube, the droplet adhesion surface area increases in said radially enlarged tube, and a large quantity of droplets can be adhered and recovered surely, so that it is possible to realize the high purification of the plasma flow.

If many droplet collecting plates of said sixth form are installed in the plasma advancing path, it is possible to increase the droplet removing area, but it is produced a problem that limit occurs in the installed number because of form conditions such as advancing path form and inner diameter. As a result that the present inventor examined zealously concerning said problem, he paid his attention to that the droplets get to adhere easily on rough surface made on the surface of said droplet collecting plate by performing the rough surface processing, and it is possible to improve the collecting efficiency of droplet. That is to say, according to the seventh form of the present invention, as a rough surface processing is made on a surface of said droplet collecting plate, the collecting area and adhering strength of said droplet collecting plate increase and the collecting efficiency improves, so that it is possible to contribute to improvement of the droplet removing efficiency.

There is a collecting effect even in the case that the droplet collecting plate is installed so as to be perpendicular to the tube axis for the inner wall of said inner circumferential tube. However, according to the eighth form of the present invention, as said droplet collecting plates are inclinedly disposed for said introduction side radially reduced tube, the droplet collecting probability based on re-reflection increases between the droplet collecting plates, and the escaping droplets become less. Furthermore, since the area receiving the droplets flowing into said radially enlarged tube becomes large, the collecting efficiency of said droplet collecting plate improves and it is possible to contribute to improvement of the droplet removing efficiency still more.

According to the ninth form of the present invention, since an droplet collecting aperture is arranged in said introduction side radially reduced tube and said discharge side radially reduced tube, by way of example only, the tube diameter of the plasma advancing path can be reduced, or the opening shape can be transformed by decentering, so that it is possible to contribute to improvement of the droplet removing efficiency by collecting the droplets straightly advancing at the initial end and the final end of the plasma advancing path.

According to the tenth form of the present invention, since a plurality of said radially enlarged tubes are connected through a radially reduced tube, it is possible to remove the droplets at plural stages and to generate the plasma flow with high purity. In this case, if the tube axes of the radially enlarged tubes are decentered, it is as described above that the droplet collecting efficiency increases.

According to the eleventh form of the present invention, since a rotational magnetic field applying means generating a rotational magnetic field in a cross section circumferential direction of said radially enlarged tube in which the plasma mixing the droplets advance is installed and said plasma mixed with said droplets advances while rotating by said rotational magnetic field, the charged droplets and small droplets can be separated from this plasma mixed with the droplets by a centrifugal force. Since said plasma mixed with the droplets advances with bending in the cross section circumferential direction of said tubular advancing path while rotating, the rotational radius enlarges gradually. Furthermore, when the plasma advanced to the region not applied with said rotational magnetic field, by the straightly advancing magnetic field applied at the terminal end side or the whole of said radially enlarged tube, the plasma approaches to the center axis of said radially enlarged tube, or straightly advances to the terminal end of said radially enlarged tube. Because the mass of droplet is larger than that of plasma constituent particle, the droplet can not follow the rapid change of the advancing direction of the plasma flow, the droplets can be removed by colliding with the wall surface in said radially enlarged tube base on the inertia force. That is to say, when being observed from the rotational coordinate system fixed on said rotational magnetic field, since said droplet receives the centrifugal force proportional to the rotational magnetic field and the mass, said droplet can be separated from said plasma mixed with droplets by this centrifugal force and it is possible to form the highly purified plasma flow. In addition, it is possible to remove small droplets by increasing of the magnetic field and to remove the charged droplets having large mass with high efficiency by said centrifugal force. Therefore, the droplet removing apparatus of the present invention can form the highly purified thin film on the object surface to be treated, and can perform the uniform surface modification on the object surface to be treated. In addition, the path in which said plasma mixed with droplets advance can be set to be a desired size by adjusting the magnetic field intensity, it is possible to miniaturize the droplet removing apparatus. Furthermore, since the plasma flow advances along the straightly advancing magnetic field direction by the electromagnetic interaction with the straightly advancing magnetic field due to the straightly advancing magnetic field generator arranged at the outer circumference of radially enlarged tube while drawing helix track, it is possible to increase the centrifugal force acting on said droplet by applying the rotational magnetic field rotating in the turning direction of said plasma to said plasma mixed with droplets. Therefore, it is possible to separate and remove said droplets from the plasma mixed with droplet with high efficiency.

According to the twelfth form of the present invention, said rotational magnetic field applying means is constituted from a plurality of vibration magnetic field generators generating vibration magnetic fields, a plurality of vibration magnetic fields with different phase and different vibration direction are generated by said vibration magnetic field generators, and said rotational magnetic field is synthesized from said vibration magnetic fields, so that it is possible to control said rotational magnetic field with high precision. Since said vibration magnetic field generator is composed of an electromagnet, by arranging the disposed position and the applied voltage, it is possible to adjust freely the phase, amplitude, frequency and vibration direction of the vibration magnetic field, and it is possible to synthesize the desired rotational magnetic field by combining a plurality of vibration magnetic fields. That is to say, the preferred rotational magnetic field can be applied according to the shape and size of said radially enlarged tube and the characteristic and condition of plasma and droplet, and it is possible to set freely the rotational direction and intensity of the rotational magnetic field. Therefore, in the case that the plasma flow advances along the advancing direction while drawing the helix track, it is possible to select freely the rotational direction of the rotational magnetic field according to the turning direction of said plasma flow. Additionally, the arrangement of each vibration magnetic field generator is set so as to be able to synthesize the desired rotational magnetic field, and it is possible to remove efficiently the droplets by the centrifugal force still more when a plurality of vibration magnetic field generators are disposed along the plasma advancing direction. In the case that said rotational magnetic field applying means is composed of two vibration magnetic field generators, since said vibration magnetic field generators can be disposed so as to make said vibration magnetic fields vertically or almost vertically each other, various rotational magnetic fields can be synthesized when said two vibration magnetic fields are assumed as X-axis component and Y-axis component, respectively. When the phase difference of said two vibration magnetic fields to be vertically or almost vertically each other is set to be 90 degrees or almost 90 degrees, it is possible to control easily the rotational magnetic field by said two vibration magnetic fields and to generate the stable rotational magnetic field. When the amplitudes of said two vibration magnetic fields are set to be the same, it is possible to maintain the rotational magnetic field intensity to be constant and to advance said plasma mixed with droplets in the tubular advancing path while rotating circularly.

When a plurality of rotational magnetic field applying means are disposed in said tubular advancing path along the advancing direction of said plasma mixed with droplet, it is possible to remove the droplets at plural stages and to supply the high purity plasma flow. When the phase of each rotational magnetic field applied by a plurality of said rotational magnetic field applying means is set to be the same phase, it is possible to control simply a plurality of rotational magnetic field applying means. That is to say, it is possible to set the control devices connected to a plurality of said rotational magnetic field applying means to be the same condition and it is also possible to adjust the plural rotational magnetic field simply. When the phase of each rotational magnetic field applied by a plurality of said rotational magnetic field applying means is set to be 180 degrees or almost 180 degrees alternately along the advancing direction of said plasma mixed with droplet, since the bending directions of said plasma mixed with droplets become the reverse direction alternately, it is possible to make the emitting direction of droplet separated by the centrifugal force turn over alternately and it can be prevented that the separated droplets re-mix into said plasma mixed with droplets. In the case that said vibration magnetic field generator is formed from the horseshoe shape magnetic material wound a coil, it is possible to apply the magnetic field generated from both ends of said coil into the radially enlarged tube, and since the magnetic field is enhanced by winding around said magnetic material, it is possible to generate the vibration magnetic field with high efficiency. Therefore, it is possible to set the self-inductance of said coil small and to increase the maximum frequency of vibration magnetic field. Furthermore, it is possible to eject the heat occurring from said coil through said horseshoe shape magnetic material.

According to the thirteenth form of the present invention, one or more apertures are arranged in said radially enlarged tube, and a passage hole is arranged at an eccentric position of said aperture. By means of a magnetic field generating means disposed on an outer circumference of said radially enlarged tube, there is formed the magnetic field of which the magnetic lines of force pass curvedly in said eccentric passage hole. As positive ion and electron composing the plasma are charged particles, said plasma passes curvedly into said eccentric passage hole while coiling around said magnetic lines of force. Since the droplets accompanied with said plasma have no electric charge, said droplets advance straightly based on inertia and jump out outward when said plasma passes curvedly into said eccentric passage hole, and they are removed by colliding with the wall surface of the aperture. Therefore, the object surface to be treated disposed ahead of the radially enlarged tube can be treated by only plasma in which the droplets are hardly contained. As thus described, because the object surface to be treated is treated by only plasma in which the droplets are hardly contained, the high purity film can be formed on the object surface to be treated. In addition, since the aperture is arranged in the radially enlarged tube, it is possible to overhaul easily the wall surfaces of aperture and tubular advancing path on which droplets bonded, and the work removing the bonded droplets can be easily performed. As thus described, the whole structure of the droplet removing apparatus can be simplified and said apparatus can be manufactured cheaply and easily.

According to the 14th form of the present invention, a plurality of apertures are arranged in said radially enlarged tube, and the adjacent eccentric passage holes of aperture are disposed so as to shift their positions each other. Therefore, the small droplets accompanied with said plasma passing through the passage hole of the first step aperture straightly advance based on the inertia and jump out outward when the plasma passes curvedly through the eccentric passage hole, and the droplets are removed by colliding with the wall surface of the second step aperture. When the plasma passes curvedly the third step aperture, the small droplets accompanied with said plasma can be removed. As thus described, by means of arranging the multiple apertures, the droplets accompanied with the plasma can be removed, and the object surface to be treated disposed ahead of the tubular advancing path can be treated with the still more highly purified plasma. Furthermore, the eccentric passage holes of the adjacent apertures can be disposed so as to shift their positions by 180 degrees in the circumferential direction, and said shifting angle such as 90 degrees and 60 degrees can be selected arbitrarily. In addition, it is also possible to form the position of the eccentric passage hole of the aperture by shifting in the radial direction.

According to the 15th form of the present invention, because said magnetic field generating means is configured with a slant magnetic field generator, by said slant magnetic field generator, there is formed a slant magnetic field by which the magnetic lines of force pass curvedly through the eccentric passage hole. Since the slant magnetic field is formed by the slant magnetic field generator, it is possible to adjust freely said slant magnetic field so as to match with the eccentric passage hole of the aperture, and it is possible to surely guide the plasma flow into this eccentric passage hole. When said slant magnetic field generator is formed by an electromagnet or a permanent magnet disposed inclinedly on the outer circumferential surface of the tubular advancing path, there is formed a slant magnetic field by which the magnetic lines of force pass curvedly through the eccentric passage hole. In the case that said slant magnetic field is formed by the electromagnet, the strongly slant magnetic field can be formed by increasing the linking number of the coil. Because the coil current can be changed by modifying the linking number of the coil, it is possible to control the magnetic field intensity from the large to the small easily. When the inclination of the electromagnet is changed, it is possible to modify and adjust the angle of the slant magnetic field easily. When the super-conduction magnet (electromagnet in which the coil is made by super-conduction line) is used as said electromagnet, there is hardly the loss of energy and it is possible to generate the strong magnetic field. Additionally, in the case that said slant magnetic field is formed by said permanent magnet, by adjusting the direction of permanent magnet, it is possible to form said slant magnetic field at the position matching with the eccentric passage hole of the aperture. Furthermore, it is possible to select freely the positions of N-pole and S-pole of the permanent magnet disposed on the outer circumference of the radially enlarged tube, and it is possible to installed simply N-pole and S-pole of this permanent magnet. When the slant magnetic field is formed from synthesizing the straightly advancing magnetic field generated by the straightly advancing magnetic field generator and the radial direction magnetic field generated by the radial direction magnetic field generator, this slant magnetic field is formed at the position at which the magnetic lines of force pass curvedly through the eccentric passage hole. By increasing the radial direction magnetic field, the plasma flow that is curved greatly can be formed, and when it passes through the eccentric passage hole, the droplets can be surely shielded and removed. When two sets of said radial direction magnetic field generator are disposed X-X axially and Y-Y axially with right angle or approximately right angle, by setting the X-X axial and Y-Y axial magnetic fields at the predetermined intensities, it is possible to form the synthesized magnetic field with a desired direction and a desired intensity. Therefore, it is possible to form the synthesized magnetic field by which the plasma is guided into the eccentric passage hole of the aperture. Moreover, when two sets of said radial direction magnetic field generator are formed by the electromagnet, by increasing the linking number of the electromagnetic coil or adjusting the coil current, it is possible to control freely the direction and intensity of synthesized magnetic field. Therefore, when the position of eccentric passage hole of aperture is set appropriately, it is possible to form easily the synthesized magnetic field suitable for the position of this eccentric passage hole.

According to the 16th form of the present invention, a duct portion for transporting said plasma includes at least said introduction side radially reduced tube, said radially enlarged tube and said discharge side radially reduced tube, and said duct portion is electrically insulated with said plasma generating portion and said plasma treating portion (plasma processing portion). That is to say, said duct portion corresponds to the whole region of plasma transporting tube of the present apparatus except said plasma generating portion and said plasma treating portion, and in many cases, the whole duct portion has the electric conductivity. But, in the case that the inner circumferential tube is inserted into the radially enlarged tube through the insulating material, said inner circumferential tube is in the electric floating state with other duct portion, and said inner circumferential tube constitutes the duct portion even in this case. Said plasma treating portion is the processing portion treating the object surface to be treated. When the insulating plate is disposed between the initial end side of said duct portion and said plasma generating portion and the insulating plate is disposed between the final end side of said duct portion and said plasma treating portion, the electric insulation is achieved. By this electric insulation, it is possible to float electrically the duct portion (plasma transporting portion). Usually, since the plasma generating portion is set at high electric potential and the plasma treating portion is grounded, by this electric insulation, the duct portion is held at the floating state separated from the high electric potential and GND. As the electromagnetic action for the plasma is eliminated by this electric floating property and the influence to the plasma transporting efficiency is also eliminated, even if the total length of the duct portion becomes long, it is possible to suppress the fall of plasma quantity and plasma density and to prevent the fall of plasma transporting efficiency.

According to the 17th form of the present invention, since a bias voltage is applied to said duct portion, by adjusting the bias electric potential of said duct portion, it becomes possible to suppress the plasma damping and to increase the plasma transporting efficiency. There are positive case and negative case in the electric potential of the duct portion. In addition, the inner circumferential tube inserted into the radially enlarged tube is also included in the duct portion. When the bias potential is applied to the radially enlarged portion, it is preferably that the bias potential is applied to the inner circumferential tube contacting with the plasma. In particular, in the case that the inner circumferential tube is electrically insulated with the outer circumferential tube, the bias potential is applied to the inner circumferential tube. The bias voltage may be applied between the inner circumferential tube and the outer circumferential tube, and also the bias voltage may be applied between the inner circumferential tube and GND, in other words, the applying formation can be selected preferably. In the positive potential, the positive ion is pushed in the transporting direction by repulsion, and in the negative potential, electron is also pushed in the transporting direction by repulsion. Which electric potential of positive and negative is applied is selected so as to increase the plasma transporting efficiency. In addition, the magnitude of potential is regulated variously, and it is selected the potential intensity to increase the plasma transporting efficiency.

According to the 18th form of the present invention, a quantity of physical property can be measured by inserting a probe into said duct portion or by utilizing said duct portion as said probe. The plasma physical property quantity is the plasma parameter such as ion density, electron density, plasma drift velocity and plasma temperature. When the probe is inserted into the duct portion, there is a case to generate the disturbance in the plasma flow, and the magnitude of probe is adjusted so as to suppress the disturbance as little as possible. The number of the inserted prove is selected variously as one or two. The duct portion in itself can be used as a probe without inserting the probe to avoid this disturbance. The polarity of electric potential applied to said prove or the duct portion used as said prove is selected from positive or negative, and the potential magnitude is variously adjusted, too. In addition, since the plasma has the electric conductivity, the plasma potential is applied to the duct portion in contact with this plasma. Therefore, without completely applying the external voltage, the plasma parameter can be measured from the plasma potential applied to said duct portion by measuring the voltage between the duct portion and GND. There is a case that the values such as wave form and wave height outputted from the prove correspond directly to said plasma parameters, and it is also possible to derive the plasma parameter by calculations. It is needless to say that the technical means applied to the prove measurement can be adjusted according to the plasma conditions.

In the process that the present invention reached completion, in order to achieve an aim of droplet reduction condition, the present inventor got the finding that the configuration factor becomes the effective element, wherein said configuration factor is one or combination of effective total length, diameter, bending number and summation of bending angle in said plasma advancing path. In there, according to the 19th form of the present invention, since one or combination of effective total length, diameter, bending number and summation of bending angle in said plasma advancing path is set so as to satisfy a droplet reduction condition, it is possible to improve still more the droplet removing effect of the said droplet removing portion disposed in said plasma advancing path.

According to the 20th form of the present invention, since said effective total length being one of said effective element is set at 1600-900 mm, it is possible to improve still more the droplet removing effect of the said droplet removing portion disposed in said plasma advancing path.

According to the 21 st form of the present invention, since said diameter being one of said effective element is set at 200-90mm, it is possible to improve still more the droplet removing effect of the said droplet removing portion disposed in said plasma advancing path.

According to the 22nd form of the present invention, since said bending number being one of said effective element is set at 3-1, it is possible to improve still more the droplet removing effect of the said droplet removing portion disposed in said plasma advancing path.

According to the 23rd form of the present invention, since said summation of bending angle being one of said effective element is set at 150-90 degrees, it is possible to improve still more the droplet removing effect of the said droplet removing portion disposed in said plasma advancing path.

Separately from said configuration factor of said effective element, the present inventor got the finding that the arc current value in said plasma generating portion can become the effective element of the droplet removal, too. That is to say, according to the 24th form of the present invention, since an arc current value in said plasma generating portion is adjusted in a range of 140-30A, it is possible to improve still more the droplet removing effect of the said droplet removing portion disposed in said plasma advancing path.

### BRIEF DESCRIPTION OF DRAWINGS

FIG.1 is an outlined schematic diagram of an example of the plasma generating apparatus concerning the present invention.
FIG.2 is a partially enlarged cross section diagram of the inner circumferential tube 36 having the droplet collecting plate 38.
FIG.3 is an outlined explanation diagram of the droplet collecting plate 38 and its structure.
FIG.4 is a graph diagram showing the relation among the effective total length of the plasma advancing path L(mm), the diameter D(mm), the bending number NB and the droplet bonding number on the object to be treated per unit area.
FIG.5 is a graph diagram showing the correlation among the summation of bending angle θ(degree) of the plasma advancing path, the arc current value I(A) and the droplet removing ratio.
FIG.6 is an outlined configuration diagram of plural radially enlarged tube.
FIG.7 is a conception diagram showing various connection forms of two radially enlarged tubes.
FIG.8 is an outlined schematic diagram of another example of the plasma generating apparatus concerning the present invention.
Fig.9 is an explanation diagram of the rotational magnetic field formed in the radially enlarged tube 3.
FIG.10 is an outlined schematic diagram of more another example of the plasma generating apparatus concerning the present invention.
FIG.11 is an explanation diagram showing the state in which the plasma passes through the eccentric passage hole of the aperture disposed in the radially enlarged tube.
FIG.12 is an explanation diagram showing the aperture with the eccentric passage hole disposed in the radially enlarged tube.
FIG.13 is an outlined schematic diagram of the conventional plasma processing apparatus.

### DENOTATION OF REFERENCE NUMERALS

- 1: plasma generating apparatus
- 2: plasma generating portion
- 3: radially enlarged tube
- 3a: wall surface
- 4: cathode
- 5: plasma advancing path
- 6: trigger electrode
- 7: connection advancing path
- 7a: main bending portion
- 7b: introduction side bending portion
- 7c: discharge side bending portion
- 8: anode
- 9: plasma mixed with droplet (droplet mixing plasma)
- 9a: plasma flow
- 9b: plasma flow
- 10: arc power supply
- 12: plasma processing portion (plasma treating portion)
- 14: object to be treated
- 16: plasma stabilizing magnetic field generator
- 18: droplet
- 20: droplet collecting portion
- 22: vibration magnetic field generator
- 22a: vibration magnetic field generator
- 13: radial direction magnetic field generator
- 23a: radial direction magnetic field generator
- 24: straightly advancing magnetic field generator
- 25: aperture
- 25a: eccentric passage hole
- 26: first magnetic field generator
- 27: cathode protector
- 28: bending magnetic field generator
- 30: second magnetic field generator
- 31: third magnetic field generator
- 32: droplet advancing path
- 33: droplet collecting plate
- 34: introduction side radially reduced tube
- 35: outer circumferential tube
- 36: inner circumferential tube
- 37: droplet collecting plate for radially reduced tube
- 38: droplet collecting plate
- 38a: rough surface
- 39: discharge side radially reduced tube
- 40: stepped portion
- 41: straightly advancing tube
- 42: plasma generating portion side insulating plate
- 44: processing portion side insulating plate
- 46: insulating material
- 48: bias power supply
- 49: probe power supply
- 50: aperture
- 51: aperture
- 102: plasma generating portion
- 104: cathode
- 106: trigger electrode
- 108: anode
- 109: plasma
- 110: power supply
- 112: plasma processing portion
- 114: object to be treated
- 116a: plasma stabilizing magnetic field generator
- 116b: plasma stabilizing magnetic field generator
- 118: cathode material particle (droplet)
- 120: droplet collecting portion
- 200: radially enlarged tube
- 201: radially enlarged tube
- 202: intermediate radially reduced tube
- 203: introduction side radially reduced tube
- 204: discharge side radially reduced tube

### BEST MODE FOR CARRYING OUT THE INVENTION

As follows, the preferred embodiments of the plasma generating apparatus concerning the present invention are explained in details based on the accompanied drawings. In the present invention, the plasma generating apparatus includes both of the apparatus which installs the plasma processing portion to process the object to be treated and the apparatus which does not install the plasma processing portion. The plasma generating apparatus having the plasma processing portion may be referred to as the plasma processing apparatus.

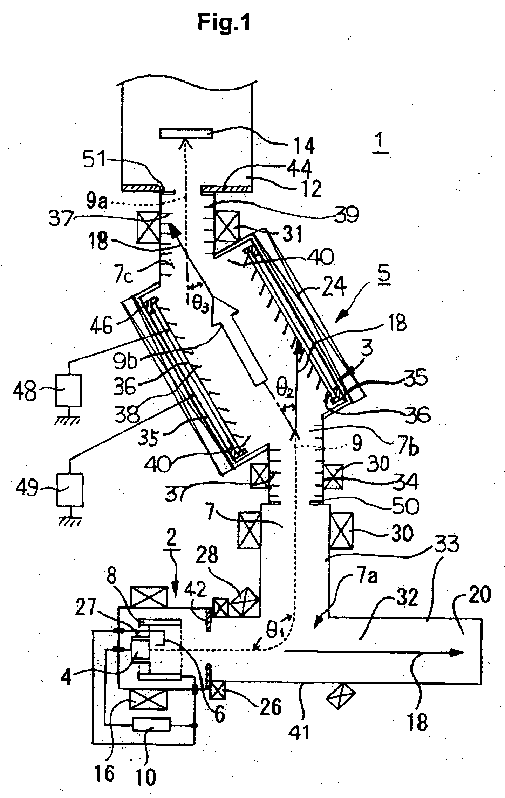

FIG.1 is an outlined schematic diagram of the plasma generating apparatus concerning the present invention. The plasma generating apparatus 1 shown in said figure is configured from the plasma generating portion 2, the plasma processing portion 12 and the plasma advancing path 5. In the plasma advancing path 5, there is disposed the droplet removing portion which removes the droplets by-produced from the cathode 4 at the plasma generating time. Said plasma removing portion is constructed from the radially enlarged tube 3 forming the plasma advancing path 5, the introduction side radially reduced tube 34 connected to the plasma introducing side initial end of said radially enlarged tube 3, the discharge side radially reduced tube 39 connected to the plasma discharge side terminal end of said radially enlarged tube 3, and the stepped portions 40 formed at the initial end and the terminal end of said radially enlarged tube 3. The connection advancing path 7 is connected to the preceding stage of the introduction side radially reduced tube 34.

The straightly advancing tube 41 is arranged ahead of the plasma generating portion 2, and said connection advancing path 7 is arranged through the main bending portion 7a with the bending angle θ1 of 90 degrees from said straightly advancing tube 41. The droplet advancing path 32 is formed in said straightly advancing tube 41 ahead from the main bending portion 7a of this connection advancing path 7. The radially enlarged tube 3 and the introduction side radially reduced tube 34 are connected so as to intersect each other through the introduction side bending portion 7b, and the bending angle θ2 of said introduction side bending portion 7b is 30 degrees in this embodiment. In addition, the bending angle θ3 between the discharge side radially reduced tube 39 and the radially enlarged tube 3 is also set at 30 degrees, so that the summation of bending angle θ(=θ1+θ2+θ3) becomes equal to 150 degrees. The radially enlarged tube 3 is composed of the inner circumferential tube 36 and the outer circumferential tube 35. The outer circumferential tube 35 does not participate in progression of the plasma, and it is the protection member of the inner circumferential tube 36, which is installed in the outer circumferential tube 35 through the insulating material such as insulating ring, so that the inner circumferential tube 36 and the outer circumferential tube 35 are electrically insulated each other. The inner circumferential tube 36 integrated with the insulating material 46 is constituted so as to be separated and taken out from the outer circumferential tube 35.

The plasma generating portion 2 comprises the cathode 4, the trigger electrode 6, the anode 8, the arc power supply 10, the cathode protector 27,and the plasma stabilizing magnetic field generator (electromagnetic coil or magnet) 16. The cathode 4 is a supply source of plasma constituent material, and the formation material is a solid having conductivity not particularly limited, so that metal simple substance, alloy, inorganic simple substance and inorganic compound (metallic oxide / nitride) etc. can be used as single substance or mixture of two substances or more. The cathode protector 27 electrically insulates except the evaporating cathode surface, and it is prevented that the plasma generated between the cathode 4 and the anode 8 diffuses backwardly. The formation material of the anode 8 is not particularly limited as far as it is a solid that does not evaporate even at the plasma temperature and are both of nonmagnetic material and conductive material. In addition, the shape of the anode 8 is not particularly limited as far as it does not shield the progression of whole arc plasma. Furthermore, the plasma stabilizing magnetic field generator 16 is disposed on the outer circumference of the plasma generating portion 2 and stabilizes the plasma. When the arc stabilizing magnetic field generator 16 is disposed so as to make the applied magnetic field to the plasma in the reverse direction (cusp form) each other, the plasma is stabilized more. In addition, the plasma generating portion 2 and the straightly advancing tube 41 are electrically insulated by the plasma generating portion side insulating plate 42, and even though the high voltage is applied to the plasma generating portion 2, the front portion from the straightly advancing tube 41 is electrically in the floating state, and it is constituted so as that the plasma is not electrically influenced in the plasma advancing path. Additionally, the processing portion side insulating plate 44 is also disposed between the discharge side radially reduced tube 39 and the plasma processing portion 12. As a result, the whole duct portion for transporting the plasma from the straightly advancing tube 41 to the discharge side radially reduced tube 39 is set in the electric floating state, so that it is constituted so as that the transported plasma is not influenced by the external power supply (high voltage and GND).

The bias power supply 48 is connected to the inner circumferential tube 36, and it is possible to set the inner circumferential tube 36 at positive potential or negative potential. When the bias potential of the inner circumferential tube 36 is the positive potential, there is the effect that the positive ion is pushed in the transporting direction, and when it is the negative potential, there is the effect that the electron in the plasma is pushed in the transporting direction. Which electric potential of positive and negative is applied is selected so as not to decrease the plasma transporting efficiency. The magnitude of potential can be also changed, and it is selected from the point of view of the plasma transporting efficiency to set usually the inner circumferential tube at +15V. In addition, the probe power supply 49 is connected to the outer circumferential tube 35, and the electric potential of said duct portion connected to the outer circumferential tube 35 is adjusted. Because the plasma in itself has the plasma potential, the potential of the duct portion becomes the synthesized potential in which the probe potential and the plasma potential are superimposed. When the synchroscope is connected between the duct portion and GND, the wave form of said synthesized potential is measured, and the plasma parameters can be measured from this peak value and period etc. In the case that the probe power supply is not connected, the potential of the duct portion becomes equal to the plasma potential, and it is possible to measure the plasma potential by connecting the synchroscope between the duct portion and GND. Since the plasma in itself has the electric conductivity, said content can be understood because of that the potential of the duct portion reflects the plasma potential.

In the plasma generating portion 2, the electric spark occurs between the cathode 4 and the trigger electrode 6, so that the vacuum arc occurs between the cathode 4 and the anode 8, and the plasma is generated. The constituent particle of this plasma includes the vaporized material from the cathode 4, the charged particle (ion, electron) originated from said vaporized material and the reaction gas, and the neutral particle of molecule and atom of plasma precursor state. Additionally, at the same time as the plasma constituent particle is emitted, the droplet 18 having the size of less than sub-micron to several hundred micron (0.01-1000µm) is emitted. This droplet 18 forms the mixed state with the plasma flow, and advances through the plasma advancing path 7 as the droplet mixing plasma 9.

In the droplet removing portion disposed in the plasma advancing path 5, the plasma flow guided from the introduction side radially reduced tube 34 to the radially enlarged tube 3 is diffused by the radially enlarging action of the plasma advancing path due to the radially enlarged tube. Although the plasma flow 9b spreads, because the droplet mixing in the plasma advances straightly, the droplets diffuse inside of the radially enlarged tube 3 while colliding with the inner wall surface of the radially enlarged tube 3. By this diffusion, the droplets decrease in the center portion of the droplet flow, and the plasma flow changes to the state that many droplets distribute at the outer circumference of the plasma flow. By this distribution change, the droplets collide with the neighborhood of the stepped portion 40 and the inner wall surface of the inner circumferential tube 36, and they are adhered and recovered. In addition, when the plasma flow in the inner circumferential tube 36 is discharged, by the radially reducing action from the inner circumferential tube 36 to the discharge side radially reduced tube 39, the droplets scattered to the inner side wall of the inner circumferential tube 36 can be prevented to join to the plasma flow 9b and to mix again. The droplets 18 jumping out from the discharge side bending portion 7c advance straightly and are recovered by colliding with the inner wall surface of the discharge side radially reduced tube 39, but the plasma flow curves along the discharge side bending portion 7c by the magnetic field and the plasma flow is separated from the droplets 18. As a result, since almost droplets 18 are separated from the plasma flow 9b and collected, the pure plasma 9a is supplied to the plasma processing portion 12. Therefore, the droplets are adhered on the neighborhood of the stepped portion 40 and the inner wall surface of the inner circumferential tube 36 and can be recovered fully, so that it is possible to remove efficiently the droplets in the plasma advancing path 5. Besides, it is possible to constitute easily and cheaply the droplet removing portion by only forming the radially enlarged tube 3 in the plasma advancing path, and when the high purity plasma obtained by improvement of the droplet removing efficiency is guided to the plasma processing portion 12, it is possible to improve the processing precision of surface treatment of filming and to improve still more the surface modification of the object surface to be treated and the uniformity of the formed film. The inner diameters of the introduction side radially reduced tube 34 and the discharge side radially reduced tube 39 are the same, and the radially enlarged degree of the inner circumferential tube 36 of the radially enlarged tube 3 to the former may be around 1.2 to 3.

As the inner circumferential tube is freely inserted to and removed from the outer circumferential tube in said radially enlarged tube, the inner circumferential tube 36 polluted by the droplets can be changed at any time, and the cleaning performance of the droplet is improved and it is possible to perform smoothly the plasma generating treatment without decreasing the running efficiency of the plasma generating apparatus.

As for the introduction side radially reduced tube 34 and the discharge side radially reduced tube 39, their tube axes are inclinedly disposed with the predetermined bending angle (θ2+θ3=60 degrees) to the tube axis of the radially enlarged tube 3, and their conjugation surfaces to the radially enlarged tube 3 become the shape of elliptic. By this, since the bending type plasma advancing path is formed by the introduction side radially reduced tube 34, the discharge side radially reduced tube 39 and the radially enlarged tube 3, the droplets diffused in the radially enlarged tube 3 can be adhered and recovered by colliding with the neighborhood of the stepped portion 40 and the inner side wall of the radially enlarged tube 3. Therefore, the droplets mixed in the plasma flow can be separated with high efficiency, and because the highly purified plasma flow is discharged (ejected) from said discharge side radially reduced tube, it is possible to improve the droplet removing efficiency.

In the present embodiment, the tube axes of the introduction side radially reduced tube 34 and the discharge side radially reduced tube 39 are connected to the initial end and the final end of the radially enlarged tube 3 in the same direction, respectively, and it is the case of parallel arrangement (θ2=30 degrees, θ3=30 degrees). In addition, for example, when the tube axis of the discharge side radially reduced tube 39 is inclined to the tube axis of the radially enlarged tube 3 in the reverse direction with 30 degrees (θ3=-30 degrees), the tube axes of the introduction side radially reduced tube 34 and the discharge side radially reduced tube 39 are intersected each other to the initial end and the final end of the radially enlarged tube 3 in the same direction, and it is the case of intersection arrangement (θ2=30 degrees, θ3=-30 degrees). Hence, the plasma flow discharged from the radially enlarged tube 3 collides with the inner wall of the discharge side radially reduced tube 39 intersecting to the introduction side radially reduced tube 34, so that it is possible to pass the plasma flow through the discharge side radially reduced tube while meandering. Therefore, in comparison with the case of said parallel arrangement, after the droplets were adhered and recovered by colliding with the neighborhood of the stepped portion 40 and the inner side wall of the inner circumferential tube 36, even if the droplets mixing in the center neighborhood of the plasma flow are discharged from the inner circumferential tube 36, the droplets advance straightly and are adhered and recovered by colliding with the inner wall of the discharge side radially reduced tube 39, and it is possible to remove the droplets with high efficiency.

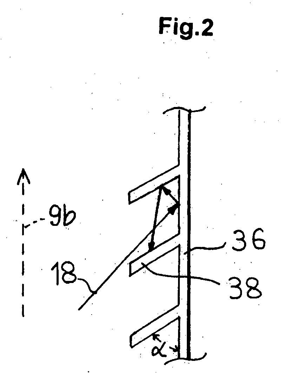

FIG.2 is a partially enlarged cross section diagram of the inner circumferential tube 36 having the droplet collecting plate 38. A plurality of droplet collecting plates 38 is installed on the inner wall of the inner circumferential tube 36. The slant angle α of the droplet collecting plate 38 is set in the range of 15 to 90 degrees, the range of 30 to 60 degrees is empirically preferable and the angle is set α=45 degrees in this example. In this slant angle, the droplets 18 separated from the plasma flow 9b can be surely adhered and recovered while multiple-reflecting the droplet collecting plate 38 as shown in the diagram.

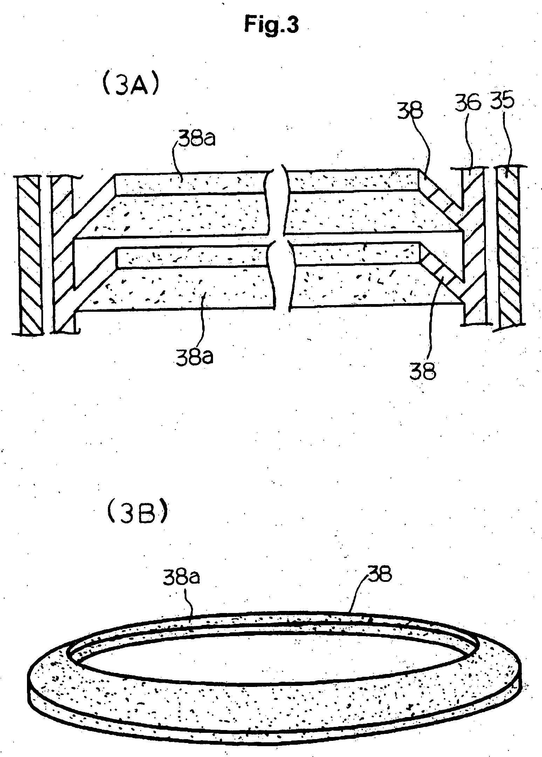

FIG.3 is a partial cross section diagram of the structure of the droplet collecting plate 38, (3A) is its partial cross section and (3B) is an appearance diagram of one sheet of droplet collecting plate 38. The droplet adhering surface area in the inner circumferential tube 36 becomes large by a plurality of droplet collecting plates 38, and it is possible to adhere and recover the scattered droplets surely and in large quantities. Because, in the plasma advancing path, the set number of sheets of droplet collecting plates 38 is limited by restriction due to the tube length of the inner circumferential tube 36, the rough surface treatment is done on the surface of the droplet collecting plate 38 to increase the droplet removing area, so that the rough surface 38a having the innumerable unevenness are formed. Because the surface of the droplet collecting plate 38 becomes the rough surface 38a, the collecting area of the droplet collecting plate 38 increases and the collecting efficiency can be improved. In addition, the droplet 18 colliding with the recess is surely bonded in the recess and the droplet collecting efficiency increases markedly. The lineage elaboration and the pear tree place elaboration can be used for said rough surface processing 38a. For example, as for the lineage elaboration method, the polish treatment with abrasive paper is used. For example, as for the pear tree place elaboration method, the blasting by alumina, shot, grid, or glass bead is used, and especially, by using the micro-abrasive blasting elaboration that the grains with several micron size are jetted through nozzle with compressed air for acceleration, it is possible to perform the convexoconcave elaboration for narrow surface of the droplet collecting plate 38.

As explained above, since the droplet collecting plate is important, it will be written down again here. The collecting surface of the droplet collecting plate 38, as shown in FIG.3, inclines to the inner wall of the inner circumferential tube 36 by about 45 degrees. Therefore, in the state that the droplet collecting plate 38 is installed in the inner circumferential tube 36, the collecting surface is inclinedly disposed toward the introduction side radially reduced tube 34, so that the area receiving the droplets flowing into the inner circumferential tube 36 increases. Therefore, by improvement of the collecting efficiency of the droplet collecting plate 38, it is possible to raise the droplet removing efficiency still more. In addition, by inclination of about 45 degrees, the collected droplets collide and reflect with the collecting surface, so that it is possible to prevent the jumping out from the collecting plate again. In FIG. 1, the similar droplets collecting plates 37 for the radially reduced tube are installed in the introduction side radially reduced tube 34 and the discharge side radially reduced tube 39, too. Although this droplet collecting plates 37 for the radially reduced tube are disposed uprightly to the inner surface of the radially reduced tube, it is needless to say that it is disposed inclinedly with appropriate slant angle at the same manner as said droplet collecting plate 18. Besides, many droplet collecting plates 33 are disposed on the inner surface of the tube wall of the connection advancing path 7 and the droplet advancing path 32, but the drawing is omitted. The inclination arrangement of these droplet collecting plates 33 is set in the sama manner as described above.

In FIG. 1, in the straightly advancing tube 32 to which the connection advancing path 7 is connected, the first magnetic field generator 26 and the bending magnetic field generator 28 are disposed, and the second magnetic field generator 30, 30 are disposed on the outer circumference of the connection advancing path 7 and the introduction side radially reduced tube 34. The straightly advancing magnetic field generator 24 is arranged on the outer circumference of the radially enlarged tube 3, and the third magnetic field generator 31 is arranged on the outer circumference of the discharge side radially reduced tube 39. The first magnetic field generator 26, the second magnetic field generator 30, the third magnetic field generator 31 and the straightly advancing magnetic field generator 24 are installed to advance the plasma forwardly. The bending magnetic field is applied by the bending magnetic field generator 28 inclinedly arranged at the bending portion 7a, so that the droplet mixing plasma 9 (plasma mixed with droplet) emitted from the plasma generating portion 2 is bent at the bending portion 7a. Then, the electrically neutral droplets 18 do not receive the influence of the bending magnetic field, so that the droplets advance through the droplet advancing path 32 by the inertial force, and they are collected by the droplet collecting portion 20 arranged at the final end of the droplet advancing path 32. Therefore, in the introduction side radially reduced tube 34 connected vertically or almost vertically to the droplet advancing path 32 through the connection advancing path 7, the plasma flow of which a part of droplets were removed beforehand flows into by the bending action of the plasma advancing path, so that the highly efficient removal of the droplets becomes possible by synergistic effect with the droplet removal due to the droplet removing portion disposed in said plasma advancing path 5. Moreover, by disposing the introduction side radially reduced tube 34 and the discharge side radially reduced tube 39 inclinedly to the radially enlarged tube 3, it is possible to increase the droplet collecting efficiency still more.

The introduction side radially reduced tube 34 is only a little radially reduced in comparison with the connection advancing path 7, and the droplet removal is done by this radially reducing action, but the droplet collecting aperture 50 is arranged in the vicinity of the connection portion with the connection advancing path 7. The droplet collecting aperture 51 is arranged near the opening of the plasma processing portion 12 side of the discharge side radially reduced tube 39. As for the aperture 50, 51, there is used the circular plate type aperture of which the opening shape is deformed so as to contract or decenter the tube diameter of the plasma advancing path and deformed so as to contract and decenter said tube diameter. By arranging these apertures 50, 51, the straightly advancing droplets are collected at the initial end and the final end of the plasma advancing path, so that it is possible to contribute the improvement of the droplet removing efficiency.

In the plasma generating apparatus 1 concerning said constitution, by the droplet collecting portion 20, the droplet removing portion of the plasma advancing path and apertures 50, 51, the droplets are removed to form the high purity plasma 9a, which advances by being guided due to the magnetic field of the third magnetic field generator 31 arranged at the discharge side radially reduced tube 39, and the object surface to be treated 14 is treated by guiding to the plasma processing portion 12. Therefore, it is possible to perform the uniform surface modification on the object surface to be treated with the high purity plasma and to form the thin film of high quality with little defect and little impurity.

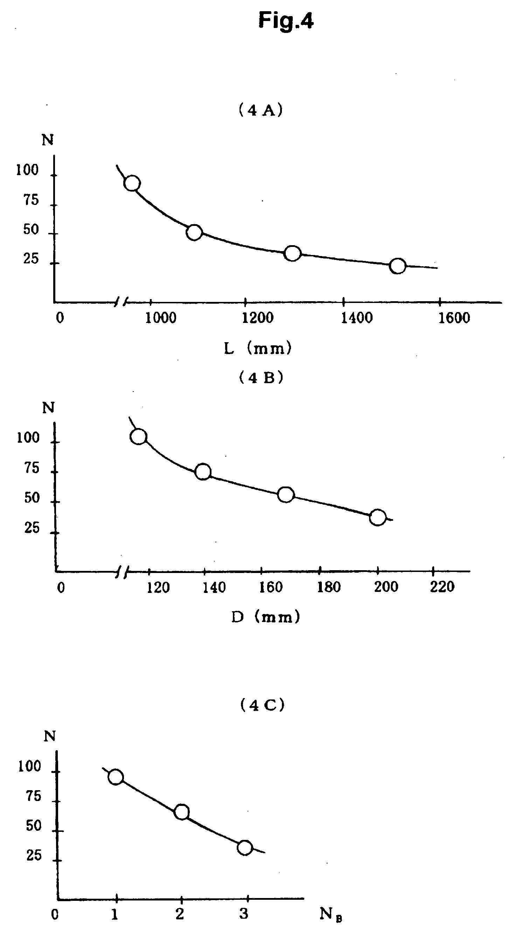

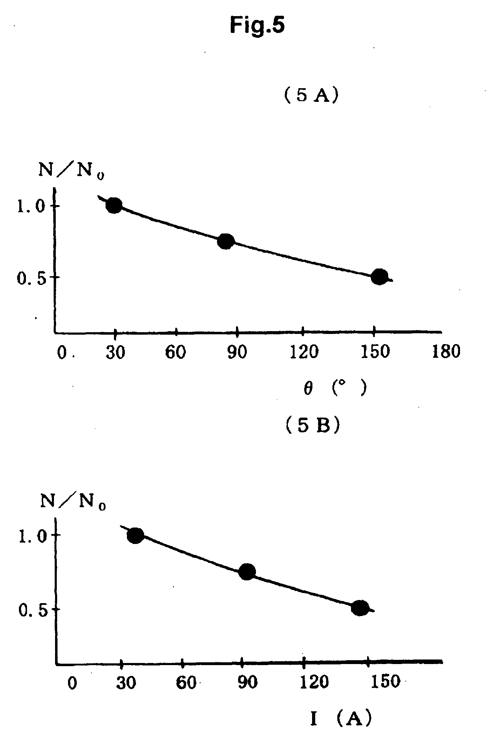

According to the findings that the present inventor got, in order to achieve an aim of droplet reduction condition, the configuration factor becomes the effective element, wherein said configuration factor is one or combination of effective total length, diameter, bending number and summation of bending angle in the plasma advancing path. FIG. 4 and FIG. 5 (5A) show the consequence that the availability on these configuration factors is inspected. In this verification, the plasma advancing path was formed by the duct of the same diameter over full length.

FIG.4 is a graph diagram showing the relation among the effective total length of the plasma advancing path L(mm), the diameter D(mm), the bending number NB and the droplet removing ratio. FIG.5 (5A) is a graph diagram showing the correlation among the summation (θ=θ1+θ2+θ3) of bending angle of the plasma advancing path and the droplet removing ratio. Longitudinal axis N in FIG. 4 shows the droplet bonding number on the object to be treated per unit area (2.5inchx2.5 inch). When, for example, the 10nm film is formed with the deposition rate of 10A/sec (A=0.1nm), N <100 was set as the desired value of the surface treatment ability in the plasma processing portion 12, namely as the desired value of the droplet reduction condition.

As found from FIG.4, said droplet reduction condition can be satisfied by setting the effective total length at 1600-900mm, by setting the tube diameter at 200-90mm, and by setting the bending number at 3-1.

The N/N0 of the longitudinal axis in FIG.5 (5A) shows the comparison with the droplet bonding number NO on the object to be treated in only the straightly plasma advancing path. The smaller the value of N/N0 is under the condition of N/N0<1, the higher the surface treatment ability in the plasma processing portion 12 becomes, so that it is set as the desired value of the droplet reduction condition. The bending angle is the angle at which the duct is bent for the advancing direction of the plasma flow. As found from FIG.5 (5A), since the summation of the bending angle is set at 150-90 degrees, said droplet reduction condition can be satisfied.

From said verification results, when one or combination of effective total length, diameter, bending number and summation of bending angle in said plasma advancing path is set so as to satisfy the droplet reduction condition, it is possible to improve still more the droplet removing effect of the said droplet removing portion disposed in said plasma advancing path. In said embodiment, the effective total length, the diameter, the bending number and the summation of bending angle in said plasma advancing path are set at 1500mm, 200mm, 3 (three positions of main bending portion 7a, introduction side bending portion 7b and discharge side bending portion 7c) and 150degrees (90+30+30), respectively, and the effective element of said configuration factor is included.

According to the findings obtained by the present inventor, separately from said configuration factor of said effective element, the arc current value in said plasma generating portion 2 can become the effective element of the droplet removal, too. FIG. 5 (5B) shows the relation of the arc current value in the plasma generating portion 2 with N/N0 of the longitudinal axis. That is to say, since the arc current value in the plasma generating portion 2 is adjusted in the range of 140-30A, in the same manner as the configuration factor of said effective element, said droplet reduction condition can be satisfied, so that it is possible to improve still more the droplet removing efficiency by using together with the droplet removing portion of the present embodiment.

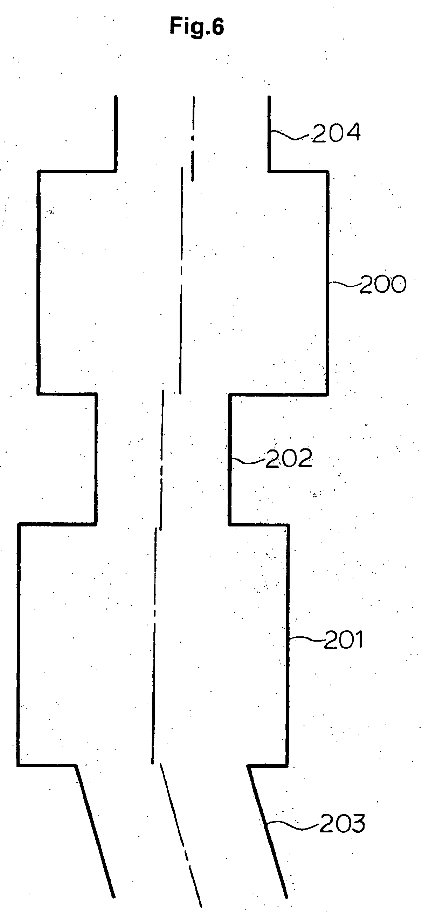

When a plurality of radially enlarged tube are connected through the radially reduced tube, it is possible to improve the droplet removing efficiency. FIG.6 is one example of plural radially enlarged tube arrangement, and shows the plasma advancing path connecting linearly two radially enlarged tubes 200, 201 through the intermediate radially reduced tube 202. The introduction side radially reduced tube 203 is inclinedly arranged to the radially enlarged tube 201, the radially enlarged tube 201 is connected to the radially enlarged tube 202 through the intermediate radially reduced tube 202, and the discharge side radially reduced tube 204 is connected to the radially enlarged tube 200. By these connected radially enlarged tubes 200, 201, the droplets can be removed over plural stages and the high purity plasma flow can be generated. Besides, as shown in the diagram, by decentering so as not to coincide the tube axes of the connected duct, it is possible to raise the droplet removing effect at the stepped portion formed in the radially enlarged tube 200, 201. In addition, when the intermediate radially reduced tube 202. is curvedly formed and the plasma inducing magnetic field generator is arranged outside, a plurality of radially enlarged tubes may be connected while increasing the bending degree of the plasma advancing path.

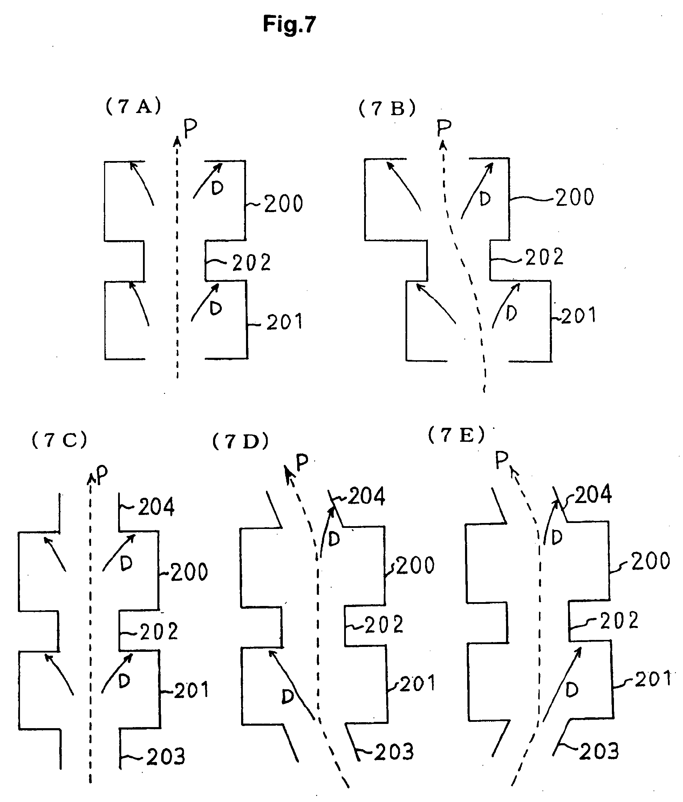

FIG.7 is the conception diagram showing various connection forms of two radially enlarged tubes. In FIG.(7A), the case coinciding the tube axes of the radially enlarged tubes 200, 201 is shown. In this case, the plasma flow P advances linearly, so that the droplet D are collected by the stepped portion and the inner circumferential surface of the radially enlarged tube. In FIG (7B), the case shifting the tube axes of the radially enlarged tubes 200, 201 is shown. In this case, the plasma flow P meanders a little and since the droplets D are sepasrated from the plasma flow P by this meandering, the collection of the droplets D at the stepped portion is strengthened. FIG.(7C) is the case that the introduction side radially reduced tube 203 and the discharge side radially reduced tube 204 are parallel arranged (θ2=0, θ3=0). The slant angle θ2, θ3 are defined in the same manner as FIG. 1. In this case, the plasma flow P advances straightly and the droplets D are collected at the stepped portion of the radially enlarged tube. FIG (7D) corresponds to the case that the introduction side radially reduced tube 203 and the discharge side radially reduced tube 204 are inclinedly arranged (θ2=-30 degrees, θ3=-30 degrees). As a result, the introduction side radially reduced tube 203 is parallel with the discharge side radially reduced tube 204. In this case, the plasma flow P meanders in sigmoid, and since the droplets D are separated from the plasma flow P by this sigmoid meandering, the collection effect of the droplets D at the stepped portion of the radially enlarged tube is strengthened. FIG.(7E) shows the case that the introduction side radially reduced tube 203 and the discharge side radially reduced tube 204 are inclinedly arranged (θ2=30degrees, θ3=-30 degrees). In this case, the introduction side radially reduced tube 203 and the discharge side radially reduced tube 204 intersects. The plasma flow P meanders curvedly, and since the droplets D are separated from the plasma flow P by this curved meandering, the collection effect of the droplets D at the stepped portion of the radially enlarged tube is strengthened. There is a choice of (7A) and (7B), furthermore there is a choice of (7C)-(7E), so that the variability spreads by the combination of both. In addition, when there are three or more radially enlarged tubes, the variability increases still more, but the basis of selection is that the droplet collecting efficiency is maximized and the fall of the plasma transporting efficiency is suppressed at largest. If the present invention is used, it becomes possible to spread the width of choice variously.

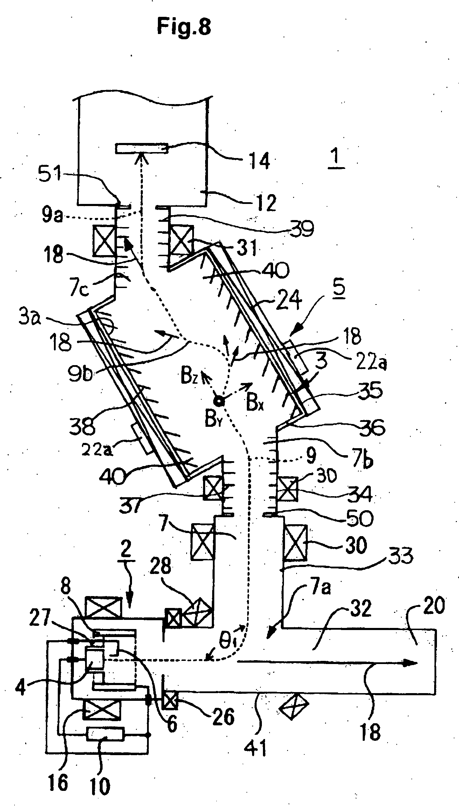

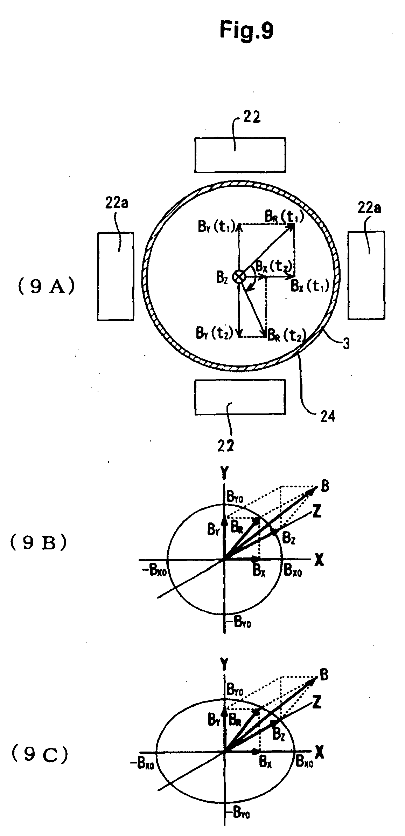

FIG.8 is the outlined schematic diagram of another example of the plasma generating apparatus concerning the present invention. The same numeral is used for the same portion as FIG.1, and its description is omitted because its operation and effect are the same. In the following, the operation and effect are described in details for the different numeral and site. In the radially enlarged portion 3, the vibration magnetic field generator 22a, 22a generating the vibration magnetic field BX in the X-axis direction and the vibration magnetic field generator 22, 22 generating the vibration magnetic field BY in the Y-axis direction (referred to FIG.9) are arranged so as that the vibration magnetic field BX and the vibration magnetic field BY are perpendicular each other. The straightly advancing magnetic field BZ in the Z-axis direction is formed by the straightly advancing magnetic field generator 24. The rotational magnetic field is constructed by the synthesized magnetic field composed of the vibration magnetic field BX and the vibration magnetic field BY, and the combination of the vibration magnetic field generator 22a, 22a and the vibration magnetic field generator 22, 22 is enumerated as the concrete example of the rotational magnetic field generator of the present invention.

The helical magnetic field is formed by synthesization of said the rotational magnetic field and said straightly advancing magnetic field. The straightly advancing magnetic field generator is configured from the electromagnetic coil wound on the outer circumference of said radially enlarged portion. Therefore, said droplet mixing plasma advances through the tubular advancing path by said rotational magnetic field and the straightly advancing magnetic field while helically rotating. By the centrifugal force based on this rotation, the droplets 18 are separated from the plasma flow 9b, and collected efficiently by the droplet collecting plate 38 and the stepped portion 40. As well as the droplet separation due to the slant angles θ2, θ3, the centrifugal separation is included in this example and the droplet separating efficiency is strengthened still more.

Fig.9 is the explanation diagram of the rotational magnetic field formed in the radially enlarged tube 3. In FIG (9A), there is shown the relation among the vibration magnetic field BX(t) at the time t based on the vibration magnetic field generator 22a, 22a, the vibration magnetic field BY(t) at the time t based on the vibration magnetic field generator 22, 22 and the rotational magnetic field BR(t) at the time t. In FIG (9A), it is shown the magnetic field applied to one position at which the plasma flow passes through said radially enlarged tube, wherein the straightly advancing magnetic field BZ is the stationary magnetic field. However, the straightly advancing magnetic field can be changed with the time. The rotational magnetic field BR(t1) is synthesized from the vibration magnetic fields BX(t1) and BY(t1) at the time t=t1.

As shown in (9B) and (9C) (time expression t is omitted), the synthesized magnetic field B is synthesized from the rotational magnetic field BR and the straightly advancing magnetic field BZ, and said droplet mixing plasma 9 advances through said radially enlarged tube 3 while being bent in the direction of the synthesized magnetic field. In the same manner, in (9A), the rotational magnetic field BR(t2) is synthesized from the vibration magnetic fields BX(t2) and BY(t2) at the time t2. That is to say, when the time t advances from t1 to t2, the vibration magnetic fields BX(t1), BY(t1) change to the vibration magnetic fields BX(t2), BY(t2), so that the rotational magnetic field BR(t) rotates from BR(t1) to BR(t2). Therefore, when the phase difference, frequency and current value of the alternating current supplied to the vibration magnetic field generators 22a, 22a, 22, 22 are adjusted, the vibration magnetic fields BX(t), BY(t) can be controlled, so that it is possible to generate the desired rotational magnetic field BR(t). Additionally, in the following, the time expression (t) is omitted, and the vibration magnetic fields BX, BY and the rotational magnetic field BR are used.

In (9B) and (9C), the relations among the vibration magnetic fields BX, BY, the straightly advancing magnetic field BZ, the rotational magnetic field BR and the synthesized magnetic field B are shown. In (9B), since the amplitude BX0 of the vibration magnetic field BX and the amplitude BY0 of the vibration magnetic field BY are set at the same values, and the vibration magnetic fields BX, BY of the phase difference 90 degrees vibrate at the same frequency, the rotational magnetic field rotates at the constant strength. Therefore, said plasma flow advances through said radially enlarged tube 3 while rotating circularly. In (9C), since the amplitude BY0 is set to be smaller than the amplitude BX0, and the vibration magnetic fields BX, BY of the phase difference 90 degrees vibrate at the same frequency, the vector of the rotational magnetic field BR of (9C) rotates in the shape of elliptic. Therefore, since the force bending in the Y direction becomes small, said plasma flow advances through said radially enlarged tube 3 while rotating in the shape of elliptic. As described above, according to the present example, it is demonstrated to be able to remove efficiently the droplets by the centrifugal force due to the circular rotation and the elliptical rotation.

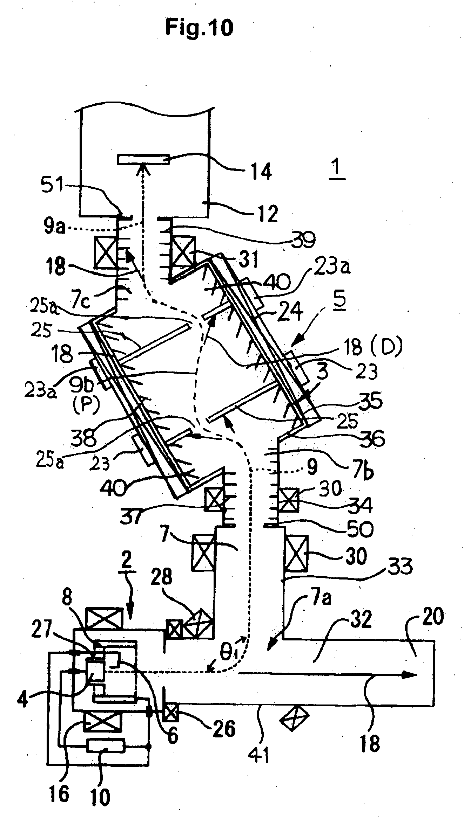

FIG.10 is the outlined schematic diagram of more another example of the plasma generating apparatus concerning the present invention. The same numeral is used for the same portion as FIG.1, and its description is omitted because its operation and effect are the same. In the following, the operation and effect are described in details for the different numeral. As shown in FIG.10, in the radially enlarged tube 3, two apertures 25 having the passage hole 25a at the eccentric position are disposed in front and back. If it is explained by an outline, when the plasma flow passes through the eccentric passage hole 25a while meandering through the radially enlarged tube 3, the droplets 18 (written as D) are separated and removed from the plasma flow 9b (written as P). That is to say, when the plasma P passes curvedly through the eccentric passage hole 25a of the aperture 25, the small droplets D accompanied with the plasma P jump out outside and are removed by colliding with the wall surface of the aperture 25.

The slant magnetic field generator is constituted from the straightly advancing magnetic field generator 24 disposed on the outer circumferential surface of the radially enlarged tube 3 and the radial direction magnetic field generator 23, 23a arranged on this circumference. The slant magnetic field is formed by the synthesization between the straightly advancing magnetic field and the radial direction magnetic field, and the plasma P progresses curvedly through the eccentric passage hole 25a of the aperture 25 while being guided by this slant magnetic field.

In FIG. 10, the eccentric passage hole 25a is formed at the left side in the initial end side aperture 25, and the eccentric passage hole 25a is formed at the right side in the final end side aperture 25. Additionally, in the radial direction magnetic field generator 23 of the initial end side, N-pole and S-pole are disposed at the right side and the left side of the figure, respectively, and in the radial direction magnetic field generator of the final end side, N-pole and S-pole are disposed at the left side and the right side of the figure, respectively. Therefore, the radial direction magnetic field from the right side to the left side is formed at the initial end side of the radially enlarged tube 3, and the radial direction magnetic field from the left side to the right side is formed at the final end side. By the synthesization of the radial direction magnetic field and the straightly advancing magnetic field due to the straightly advancing magnetic field generator 24, the slant magnetic field to a little left direction occurs at the initial end side of the radially enlarged tube 3, and the slant magnetic field to a little right direction occurs at the final end side. The plasma P is guided by the slant magnetic field to a little left direction at the initial end side of the radially enlarged tube 3 and curved in the left direction, so that the plasma passes the eccentric passage hole 25a of the initial end side aperture 25. The plasma P is guided by the slant magnetic field to a little right direction at the final end side and curved in the right direction, so that the plasma passes the eccentric passage hole 25a of the final end side aperture 25.

Small droplets D accompanied with the plasma P jump out outside by the bending of the plasma P, and are removed by colliding with the wall surface of the initial end side aperture 25 and the final end side aperture 25. Therefore, the surface of the object to be treated in the plasma processing portion 12 can be treated by the high purity plasma not including the droplets. In addition, in the discharge side radially reduced tube 39, the third magnetic field generator 31 is disposed to advance the plasma 9a toward the plasma processing portion 12.

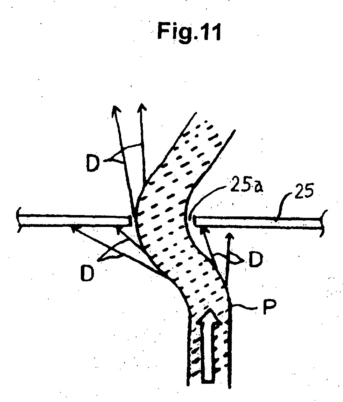

FIG.11 is the explanation diagram showing the state in which the plasma passes through the eccentric passage hole of the aperture disposed in the radially enlarged tube. As shown in FIG.11, when the plasma P passes curvedly through the eccentric passage hole 25a of the aperture 25 disposed in the radially enlarged tube 3, the small droplets D accompanied with this plasma P jump out outside at the bending time of the plasma P. The small droplets D jumping out to the initial end side are removed by colliding with the wall surface of the aperture 25. The small droplets D jumping out to the final end side are removed by colliding with the wall surface of the final end side aperture 25 not illustrated.

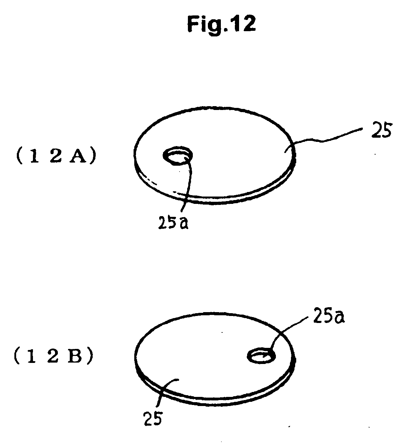

FIG.12 shows the aperture disposed in the radially enlarged tube, (12A) is a perspective diagram of aperture 25 having the eccentric passage hole 25a at the left side and (12B) is a perspective diagram of aperture 25 having the eccentric passage hole 25a at the right side. As shown in (12A), in the aperture 25 disposed at the initial end side of the radially enlarged tube 3, the eccentric passage hole 25a is formed at the left side of the figure, and the plasma P passes curvedly the eccentric passage hole 25a of this left side. As shown in (12B), in the aperture 25 disposed at the final end side of the radially enlarged tube 3, the eccentric passage hole 25a is formed at the right side of the figure, and the plasma P passes curvedly the eccentric passage hole 25a of this right side. As well as the droplet separation due to said slant angles 62, θ3, the meandering separation is added in this example, hence the droplet separating efficiency is strengthened still more, and it is verified that the droplets can be removed efficiently.

### INDUSTRIAL APPLICABILITY

The plasma generating apparatus of the present invention arranges the droplet removing portion in the plasma advancing path, so that the uniform plasma flow with high purity can be guided to the plasma treating portion. In addition, by forming the radially enlarged tube in the plasma advancing path, the droplet removing portion can be constituted easily and cheaply. Furthermore, when it is used the high purity plasma that is generated by the plasma generating apparatus of the present invention, the high purity thin film hardly including defects and impurities is formed on the surface of solid material in plasma and the uniform modification of the surface characteristics of solid can be performed without giving the defects and impurities by irradiating said plasma, by way of example only, the abrasion resistance, corrosion resistance reinforcement film, protective film, optics thin film and transparent conductivity film of the solid surface can be formed with high quality and high precision.

## Claims

1. In a plasma generating apparatus including
a plasma generating portion (2) by which a plasma is generated by a vacuum arc discharge under a vacuum atmosphere,
a plasma advancing path (5) in which said plasma generated by said plasma generating portion (2) progresses to a plasma treating portion (12) side,
and a droplet removing portion by which cathode material particles (referred to as droplets (18)) by-produced from a cathode (4) at a plasma generating time are removed,
said plasma generating apparatus **characterized in that**
said droplet removing portion is disposed in said plasma advancing path (5),
wherein
said droplet removing portion includes
a radially enlarged tube (3),
an introduction side radially reduced tube (34) connected to a plasma introducing side initial end of said radially enlarged tube (3),
a discharge side radially reduced tube (39) connected to a plasma discharge side terminal end of said radially enlarged tube (3),
and stepped portions (40) formed at said initial end and said terminal end of said radially enlarged tube (3).

2. The plasma generating apparatus according to Claim 1, wherein tube axes of said introduction side radially reduced tube (34) and/or said discharge side radially reduced tube (39) are inclinedly disposed for a tube axis of said radially enlarged tube (3), and said introduction side radially reduced tube (34) and/or said discharge side radially reduced tube (39) are connected to said radially enlarged tube (3).

3. The plasma generating apparatus according to Claim 1 or 2, wherein said tube axes of said introduction side radially reduced tube (34) and said discharge side radially reduced tube (39) are disposed so as to intersect each other.

4. The plasma generating apparatus according to Claim 2 or 3, wherein said plasma advancing path (5) includes a straightly advancing tube (41), said introduction side radially reduced tube (34) is connected vertically or almost vertically to said straightly advancing tube (41), and a droplet collecting portion (20) is disposed at a terminal end of said straightly advancing tube (41).

5. The plasma generating apparatus according to any of Claims 2 to 4, wherein said radially enlarged tube (3) is composed of an inner circumferential tube (36) and an outer circumferential tube (35), and said inner circumferential tube (36) is freely inserted to and removed from said outer circumferential tube (35).

6. The plasma generating apparatus according to Claim 5, wherein a plurality of droplet collecting plates (33) are installed on an inner wall of said inner circumferential tube (36).

7. The plasma generating apparatus according to Claim 6, wherein a rough surface processing is made on a surface of said droplet collecting plate (33).

8. The plasma generating apparatus according to Claim 7, wherein said droplet collecting plates (33) are inclinedly disposed for said introduction side radially reduced tube (34).

9. The plasma generating apparatus according to any of Claims 1 to 8, wherein droplet collecting apertures are arranged in said introduction side radially reduced tube (34) and said discharge side radially reduced tube (39).

10. The plasma generating apparatus according to any of Claims 1 to 9, wherein a plurality of said radially enlarged tubes (3) are connected through a radially reduced tube.

11. The plasma generating apparatus according to any of Claims 1 to 10, wherein one or more rotational magnetic field applying means generating a rotational magnetic field (BR) in a cross section circumferential direction of said radially enlarged tube (3) is installed, said rotational magnetic field (BR) is applied to said plasma by said rotational magnetic field applying means, and said plasma progresses through said radially enlarged tube (3) while rotating, so that said droplets (18) are removed by a centrifugal force.

12. The plasma generating apparatus according to Claim 11, wherein said rotational magnetic field applying means is constituted from a plurality of vibration magnetic field generators (22) generating vibration magnetic fields, a plurality of vibration magnetic fields with different phase and different vibration direction are generated by said vibration magnetic field generators (22), so that said rotational magnetic field (BR) is synthesized from said vibration magnetic fields.

13. The plasma generating apparatus according to any of Claims 1 to 10, wherein one or more apertures (25) having a passage hole (25a) at an eccentric position are arranged in said radially enlarged tube (3), a magnetic field generating means is disposed on an outer circumference of said radially enlarged tube (3) to pass said plasma in said eccentric passage hole (25a) of said aperture (25), and said plasma passes in said eccentric passage hole (25a) of said aperture (25) while curving in said radially enlarged tube (3) by said magnetic field based on said magnetic field generating means, so that said droplets (18) are separated from said plasma at said curving time and said droplets (18) are removed by collision with a wall surface of said aperture (25).

14. The plasma generating apparatus according to Claim 13, wherein a plurality of apertures (25) are arranged in said radially enlarged tube (3), and the adjacent eccentric passage holes (25a) are disposed so as to shift their positions each other, so that said droplets (18) accompanied with said plasma passing through said eccentric passage hole (25a) of said aperture (25) of an initial side are removed by collision with said wall surface of next aperture (25) and said plasma passes through said eccentric passage hole (25a) of next aperture (25).

15. The plasma generating apparatus according to Claim 13 or 14, wherein said magnetic field generating means is configured with a slant magnetic field generator, by which a slant magnetic field is formed in a slant direction for an axis direction of said radially enlarged tube (3) and said plasma passes through said eccentric passage hole (25a) of said aperture (25) by said slant magnetic field.

16. The plasma generating apparatus according to any of Claims 1 to 15, wherein a duct portion for transporting said plasma includes at least said introduction side radially reduced tube (34), said radially enlarged tube (3) and said discharge side radially reduced tube (39), and said duct portion is electrically insulated with said plasma generating portion (2) and said plasma treating portion (12).

17. The plasma generating apparatus according to any of Claims 1 to 16, wherein a bias voltage is applied to said duct portion.

18. The plasma generating apparatus according to any of Claims 1 to 17, wherein a quantity of physical property is measured by inserting a probe into said duct portion or by utilizing said duct portion as said probe.

19. The plasma generating apparatus according to any of Claims 1 to 18, wherein one or combination of effective total length, diameter, bending number and summation of bending angle in said plasma advancing path (5) is set so as to satisfy a droplet reduction condition.

20. The plasma generating apparatus according to Claim 19, wherein said effective total length is set at 1600-900mm.

21. The plasma generating apparatus according to Claim 19, wherein said diameter is set at 200-90mm.

22. The plasma generating apparatus according to Claim 19, wherein said bending number is set at 3-1.

23. The plasma generating apparatus according to Claim 19, wherein said summation of bending angle is set at 150-90°.

24. The plasma generating apparatus according to any of Claims 1 to 23, wherein an arc current value in said plasma generating portion (2) is adjusted in a range of 140-30A.

## Patentansprüche

1. Plasmaerzeugungsvorrichtung mit
einem Plasmaerzeugungsabschnitt (2), durch den ein Plasma durch eine Vakuumbogenentladung unter einer Vakuumatmosphäre erzeugt wird,
einem Plasmavorschubweg (5), in dem sich das Plasma, das von dem Plasmaerzeugungsabschnitt (2) erzeugt wird, zu einer Seite eines Plasmabehandlungsabschnitts (12) fortbewegt,
und einem Tropfenentfernungsabschnitt, durch den Kathodenmaterialteilchen (als Tropfen (18) bezeichnet), die zu einem Plasmaerzeugungszeitpunkt als Nebenprodukt aus einer Kathode (4) hervorgehen, entfernt werden,
wobei die Plasmaerzeugungsvorrichtung **dadurch gekennzeichnet ist, dass**
der Tropfenentfernungsabschnitt in dem Plasmavorschubweg (5) angeordnet ist,
wobei
der Plasmatropfen-Entfernungsabschnitt Folgendes aufweist
ein radial vergrößertes Rohr (3),
ein an einer Einführseite radial reduziertes Rohr (34), das mit einem Anfangsende einer Plasmaeinführseite des radial vergrößerten Rohrs (3) verbunden ist,
ein an einer Abgabeseite radial reduziertes Rohr (39), das mit einem abschließenden Ende einer Plasmaabgabeseite des radial vergrößerten Rohrs (3) verbunden ist,
und stufenförmige Abschnitte (40), die an dem Anfangsende und dem abschließenden Ende des radial vergrößerten Rohrs (3) ausgebildet sind.

2. Plasmaerzeugungsvorrichtung nach Anspruch 1, wobei Rohrachsen des an der Einführseite radial reduzierten Rohrs (34) und/oder des an der Abgabeseite radial reduzierten Rohrs (39) für eine Rohrachse des radial vergrößerten Rohrs (3) geneigt angeordnet sind, wobei das an der Einführseite radial reduzierte Rohr (34) und/oder das an der Abgabeseite radial reduzierte Rohr (39) mit dem radial vergrößerten Rohr (3) verbunden sind.

3. Plasmaerzeugungsvorrichtung nach Anspruch 1 oder 2,
wobei die Rohrachsen des an der Einführseite radial reduzierten Rohrs (34) und des an der Abgabeseite radial reduzierten Rohrs (39) derart angeordnet sind, dass sie einander schneiden.

4. Plasmaerzeugungsvorrichtung nach Anspruch 2 oder 3,
wobei der Plasmavorschubweg (5) ein gerade verlaufendes Rohr (41) aufweist, wobei das an der Einführseite radial reduzierte Rohr (34) vertikal oder nahezu vertikal mit dem gerade verlaufenden Rohr (41) verbunden ist und ein Tropfensammelabschnitt (20) an einem abschließenden Ende des gerade verlaufenden Rohrs (41) angeordnet ist.

5. Plasmaerzeugungsvorrichtung nach einem der Ansprüche 2 bis 4, wobei das radial vergrößerte Rohr (3) aus einem inneren Umfangsrohr (36) und einem äußeren Umfangsrohr (35) zusammengesetzt ist und das innere Umfangsrohr (36) frei in das äußere Umfangsrohr (35) eingesetzt und aus diesem entfernt wird.

6. Plasmaerzeugungsvorrichtung nach Anspruch 5, wobei mehrere Tropfensammelplatten (33) an einer Innenwand des inneren Umfangsrohrs (36) installiert sind.

7. Plasmaerzeugungsvorrichtung nach Anspruch 6, wobei eine raue Oberflächenbearbeitung auf einer Oberfläche der Tropfensammelplatte (33) ausgeführt ist.

8. Plasmaerzeugungsvorrichtung nach Anspruch 7, wobei die Tropfensammelplatten (33) für das an der Einführseite radial reduzierte Rohr (34) geneigt angeordnet sind.

9. Plasmaerzeugungsvorrichtung nach einem der Ansprüche 1 bis 8, wobei Tropfensammelöffnungen in dem auf der Einführseite radial reduzierten Rohr (34) und dem auf der Abgabeseite radial reduzierten Rohr (39) angeordnet sind.

10. Plasmaerzeugungsvorrichtung nach einem der Ansprüche 1 bis 9, wobei mehrere der radial vergrößerten Rohre (3) durch ein radial reduziertes Rohr verbunden sind.

11. Plasmaerzeugungsvorrichtung nach einem der Ansprüche 1 bis 10, wobei ein oder mehrere Mittel zum Anlegen eines Drehmagnetfeldes, die ein Drehmagnetfeld (BR) in einer Querschnittsumfangsrichtung des radial vergrößerten Rohrs (3) erzeugen, installiert sind,
wobei das Drehmagnetfeld (BR) an das Plasma durch die Mittel zum Anlegen eines Drehmagnetfeldes angelegt wird und sich das Plasma durch das radial vergrößerte Rohr (3) fortbewegt, während es sich dreht, sodass die Tropfen (18) durch eine Zentrifugalkraft entfernt werden.

12. Plasmaerzeugungsvorrichtung nach Anspruch 11, wobei die Mittel zum Anlegen eines Drehmagnetfeldes aus mehreren Vibrationsmagnetfeldgeneratoren (22) gebildet sind, die Vibrationsmagnetfelder erzeugen, wobei mehrere Vibrationsmagnetfelder mit unterschiedlicher Phase und unterschiedlicher Vibrationsrichtung von den Vibrationsmagnetfeldgeneratoren (22) erzeugt werden, sodass das Drehmagnetfeld (BR) aus den Vibrationsmagnetfeldern synthetisiert wird.

13. Plasmaerzeugungsvorrichtung nach einem der Ansprüche 1 bis 10, wobei eine oder mehrere Öffnungen (25), die ein Durchgangsloch (25a) an einer exzentrischen Position aufweisen, in dem radial vergrößerten Rohr (3) angeordnet sind, Magnetfeld-Erzeugungsmittel an einem äußeren Umfang des radial vergrößerten Rohrs (3) angeordnet sind, um das Plasma durch das exzentrische Durchgangsloch (25a) der Öffnung (25) durchzuleiten, wobei das Plasma durch das exzentrische Durchgangsloch (25a) der Öffnung (25) geleitet wird, während es sich in dem radial vergrößerten Rohr (3) durch das Magnetfeld basierend auf den Magnetfeld-Erzeugungsmitteln krümmt, sodass die Tropfen (18) von dem Plasma zum Krümmungszeitpunkt getrennt werden und die Tropfen (18) durch Kollision mit einer Wandoberfläche der Öffnung (25) entfernt werden.

14. Plasmaerzeugungsvorrichtung nach Anspruch 13, wobei mehrere Öffnungen (25) in dem radial vergrößerten Rohr (3) angeordnet sind und die benachbarten exzentrischen Durchgangslöcher (25a) derart angeordnet sind, dass sie ihre Positionen zueinander verschieben, sodass die Tropfen (18), die mit dem Plasma einhergehen, das durch das exzentrische Durchgangsloch (25a) der Öffnung (25) einer Anfangsseite geleitet wird, durch Kollision mit der Wandoberfläche der nächsten Öffnung (25) entfernt werden und das Plasma durch das exzentrische Durchgangsloch (25a) der nächsten Öffnung (25) geleitet wird.

15. Plasmaerzeugungsvorrichtung nach Anspruch 13 oder 14,
wobei die Magnetfeld-Erzeugungsmittel mit einem Magnetfeldgenerator konfiguriert sind, durch den ein schräges Magnetfeld in einer schrägen Richtung für eine Achsenrichtung des radial vergrößerten Rohrs (3) gebildet wird und das Plasma durch das exzentrische Durchgangsloch (25a) der Öffnung (25) mittels des schrägen Magnetfeldes geleitet wird.

16. Plasmaerzeugungsvorrichtung nach einem der Ansprüche 1 bis 15, wobei ein Kanalabschnitt für den Transport des Plasmas mindestens das an der Einführseite radial reduzierte Rohr (34), das radial vergrößerte Rohr (3) und das an der Abgabeseite radial reduzierte Rohr (39) aufweist und der Kanalabschnitt mit dem Plasmaerzeugungsabschnitt (2) und dem Plasmabehandlungsabschnitt (12) elektrisch isoliert ist.

17. Plasmaerzeugungsvorrichtung nach einem der Ansprüche 1 bis 16, wobei eine Vorspannung an den Kanalabschnitt angelegt wird.

18. Plasmaerzeugungsvorrichtung nach einem der Ansprüche 1 bis 17, wobei eine Menge einer physikalischen Eigenschaft durch Einsetzen einer Sonde in den Kanalabschnitt oder durch Benutzen des Kanalabschnitts als die Sonde gemessen wird.

19. Plasmaerzeugungsvorrichtung nach einem der Ansprüche 1 bis 18, wobei eine von oder eine Kombination einer effektiven Gesamtlänge, eines Durchmessers, einer Biegezahl und einer Summierung eines Biegewinkels in dem Plasmavorschubweg (5) derart eingestellt wird, dass sie eine Tropfenreduzierungsbedingung erfüllt.

20. Plasmaerzeugungsvorrichtung nach Anspruch 19, wobei die effektive Gesamtlänge auf 1600 bis 900 mm eingestellt ist.

21. Plasmaerzeugungsvorrichtung nach Anspruch 19, wobei der Durchmesser auf 200 bis 90 mm eingestellt ist.

22. Plasmaerzeugungsvorrichtung nach Anspruch 19, wobei die Biegezahl auf 3 bis 1 eingestellt ist.

23. Plasmaerzeugungsvorrichtung nach Anspruch 19, wobei die Summierung des Biegewinkels auf 150 bis 90° eingestellt ist.

24. Plasmaerzeugungsvorrichtung nach einem der Ansprüche 1 bis 23, wobei ein Bogenstromwert in dem Plasmaerzeugungsabschnitt (2) in einem Bereich von 140 bis 30A eingestellt ist.

## Revendications

1. Dans un appareil générateur de plasma comprenant :
une partie génératrice de plasma (2) par laquelle un plasma est généré par une décharge en arc sous vide sous atmosphère de vide,
un trajet d'avancement du plasma (5) dans lequel ledit plasma généré par ladite partie génératrice de plasma (2) progresse vers un côté de la partie de traitement de plasma (12), et
une partie d'élimination de gouttelettes par laquelle des particules de matériau cathodique (dénommées gouttelettes (18)) sous-produites par une cathode (4) au cours d'une période génératrice de plasma sont éliminées,
ledit appareil générateur de plasma étant **caractérisé en ce que** :
ladite partie d'élimination de gouttelettes est disposée dans ledit trajet d'avancement du plasma (5),
dans lequel :
ladite partie d'élimination de gouttelettes comprend :
un tube radialement élargi (3),
un tube radialement réduit côté introduction (34) raccordé à une extrémité initiale côté introduction du plasma dudit tube radialement élargi (3),
un tube radialement réduit côté décharge (39) raccordé à une extrémité terminale côté décharge de plasma dudit tube radialement élargi (3), et
des parties étagées (40) formées à ladite extrémité initiale et à ladite extrémité terminale dudit tube radialement élargi (3).

2. Appareil générateur de plasma selon la revendication 1, dans lequel les axes dudit tube radialement réduit côté introduction (34) et/ou dudit tube radialement réduit côté décharge (39) sont disposés avec une certaine inclinaison par rapport à l'axe dudit tube radialement élargi (3) et ledit tube radialement réduit côté introduction (34) et/ou ledit tube radialement réduit côté décharge (39) sont raccordés audit tube radialement élargi (3).

3. Appareil générateur de plasma selon la revendication 1 ou la revendication 2, dans lequel lesdits axes dudit tube radialement réduit côté introduction (34) et dudit tube radialement réduit côté décharge (39) sont disposés de manière à se couper l'un l'autre.

4. Appareil générateur de plasma selon la revendication 2 ou la revendication 3, dans lequel ledit trajet d'avancement du plasma (5) comprend un tube d'avancement rectiligne (41), ledit tube radialement réduit côté introduction (34) est raccordé verticalement ou presque verticalement audit tube d'avancement rectiligne (41) et une partie collectrice de gouttelettes (20) est disposée à une extrémité terminale dudit tube d'avancement rectiligne (41).

5. Appareil générateur de plasma selon l'une quelconque des revendications 2 à 4, dans lequel ledit tube radialement élargi (3) est composé d'un tube circonférentiel interne (36) et d'un tube circonférentiel externe (35) et ledit tube circonférentiel interne (36) est librement inséré et retiré dudit tube circonférentiel externe (35).

6. Appareil générateur de plasma selon la revendication 5, dans lequel une pluralité de plaques collectrices de gouttelettes (33) sont installées sur une paroi interne dudit tube circonférentiel interne (36).

7. Appareil générateur de plasma selon la revendication 6, dans lequel un traitement de surface grossier est réalisé sur une surface de ladite plaque collectrice de gouttelettes (33).

8. Appareil générateur de plasma selon la revendication 7, dans lequel lesdites plaques collectrices de gouttelettes (33) sont disposées inclinées pour ledit tube radialement réduit côté introduction (34).

9. Appareil générateur de plasma selon l'une quelconque des revendications 1 à 8, dans lequel des ouvertures collectrices de gouttelettes sont aménagées dans ledit tube radialement réduit côté introduction (34) et dans ledit tube radialement réduit côté décharge (39).

10. Appareil générateur de plasma selon l'une quelconque des revendications 1 à 9, dans lequel une pluralité desdits tubes radialement élargis (3) sont raccordés via un tube radialement réduit.

11. Appareil générateur de plasma selon l'une quelconque des revendications 1 à 10, dans lequel un ou plusieurs moyens d'application de champ magnétique rotatif générant un champ magnétique rotatif (BR) dans une direction circonférentielle en coupe transversale dudit tube radialement élargi (3) est ou sont installés, ledit champ magnétique rotatif (BR) est appliqué audit plasma par lesdits moyens d'application de champ magnétique rotatif et ledit plasma progresse à travers ledit tube radialement élargi (3) tout en tournant de sorte que lesdites gouttelettes (18) soient éliminées par la force centrifuge.

12. Appareil générateur de plasma selon la revendication 11, dans lequel lesdits moyens d'application de champ magnétique rotatif sont constitués d'une pluralité de générateurs de champs magnétiques vibratoires (22) générant des champs magnétiques vibratoires, une pluralité de champs magnétiques vibratoires de phase différente et de direction de vibration différente sont générés par lesdits générateurs de champs magnétiques vibratoires (22) de sorte que ledit champ magnétique rotatif (BR) soit synthétisé à partir desdits champs magnétiques vibratoires.

13. Appareil générateur de plasma selon l'une quelconque des revendications 1 à 10, dans lequel une ou plusieurs ouvertures (25) ayant un trou de passage (25a) en position excentrique sont aménagées dans ledit tube radialement élargi (3), un moyen générateur de champ magnétique est disposé sur une circonférence externe dudit tube radialement élargi (3) pour faire passer ledit plasma dans ledit trou de passage excentrique (25a) de ladite ouverture (25) et ledit plasma passe dans ledit trou de passage excentrique (25a) de ladite ouverture (25) tout en s'incurvant dans ledit tube radialement élargi (3) par ledit champ magnétique basé sur ledit moyen générateur de champ magnétique de sorte que les gouttelettes (18) soient séparées dudit plasma au cours de la période de courbure et que lesdites gouttelettes (18) soient éliminées par collision avec un surface de paroi de ladite ouverture (25).

14. Générateur de plasma selon la revendication 13, dans lequel une pluralité d'ouvertures (25) sont aménagées dans ledit tube radialement élargi (3) et les trous de passage excentriques adjacents (25a) sont disposés de manière à décaler leurs positions mutuelles de sorte que lesdites gouttelettes (18) accompagnées par ledit plasma passant à travers ledit trou de passage excentrique (25a) de ladite ouverture (25) d'un côté initial soient éliminées par collision avec ladite surface de paroi de l'ouverture suivante (25) et que ledit plasma passe à travers ledit trou de passage excentrique (25a) de l'ouverture suivante (25).

15. Appareil générateur de plasma selon la revendication 13 ou la revendication 14, dans lequel ledit moyen générateur de champ magnétique est configuré avec un générateur de champ magnétique incliné, dans lequel un champ magnétique incliné est formé dans une direction inclinée par rapport à la direction de l'axe dudit tube radialement élargi (3) et ledit plasma passe à travers ledit trou de passage excentrique (25a) de ladite ouverture (25) sous l'action dudit champ magnétique incliné.

16. Appareil générateur de plasma selon l'une quelconque des revendications 1 à 15, dans lequel une partie de conduit permettant de transporter ledit plasma comprend ledit tube radialement réduit côté introduction (34), ledit tube radialement élargi (3) et ledit tube radialement réduit côté décharge (39) et ladite partie de conduit est isolée électriquement par ladite partie génératrice de plasma (2) et ladite partie de traitement de plasma (12).

17. Appareil générateur de plasma selon l'une quelconque des revendications 1 à 16, dans lequel une tension de polarisation est appliquée à ladite partie de conduit.

18. Appareil générateur de plasma selon l'une quelconque des revendications 1 à 17, dans lequel la quantité de propriété physique est mesurée en insérant une sonde dans ladite partie de conduit ou en utilisant ladite partie de conduit comme ladite sonde.

19. Appareil générateur de plasma selon l'une quelconque des revendications 1 à 18, dans lequel une ou une combinaison de longueur totale efficace, de diamètre, de numéro de flexion et de sommation de l'angle de flexion dans ledit trajet d'avancement de plasma (5) est réglé(e) de manière à satisfaire à la condition de réduction des gouttelettes.

20. Appareil générateur de plasma selon la revendication 19, dans lequel ladite longueur totale efficace est réglée à 1600-900 mm.

21. Appareil générateur de plasma selon la revendication 19, dans lequel ledit diamètre est réglé à 200-90 mm.

22. Appareil générateur de plasma selon la revendication 19, dans lequel ledit numéro de flexion est réglé à 3-1.

23. Appareil générateur de plasma selon la revendication 19, dans lequel ladite sommation de l'angle de flexion est réglé à 150-90°.

24. Appareil générateur de plasma selon l'une quelconque des revendications 1 à 23, dans lequel une valeur de courant d'arc dans ladite partie génératrice de plasma (2) est ajustée dans une plage de 140 à 30 A.
